(19) Europäisches Patentamt / European Patent Office / Office européen des brevets

(11) **EP 1 872 940 A1**

(12) **EUROPEAN PATENT APPLICATION**
published in accordance with Art. 153(4) EPC

(43) Date of publication:
**02.01.2008 Bulletin 2008/01**

(51) Int Cl.:
***B32B 27/34*** *(2006.01)*

(21) Application number: **05757941.9**

(86) International application number:
**PCT/JP2005/012624**

(22) Date of filing: **01.07.2005**

(87) International publication number:
**WO 2006/114902 (02.11.2006 Gazette 2006/44)**

(84) Designated Contracting States:
**AT BE BG CH CY CZ DE DK EE ES FI FR GB GR HU IE IS IT LI LT LU MC NL PL PT RO SE SI SK TR**

(30) Priority: **20.04.2005 JP 2005122566**
**20.04.2005 JP 2005122567**
**20.04.2005 JP 2005122568**
**20.04.2005 JP 2005122569**

(71) Applicant: **Toyo Boseki Kabushiki Kaisha**
**Osaka-shi, Osaka 530-8230 (JP)**

(72) Inventors:
• **YOSHIDA, Takefumi,**
**Toyo Boseki Kabushiki Kaisha**
**Ohtsu-shi, Shiga 520-0292 (JP)**
• **TSUTSUMI, Masayuki,**
**Toyo Boseki Kabushiki Kaisha**
**Ohtsu-shi, Shiga 520-0292 (JP)**
• **KAWAHARA, Keizo,**
**Toyo Boseki Kabushiki Kaisha**
**Ohtsu-shi, Shiga 520-0292 (JP)**
• **MAEDA, Satoshi,**
**Toyo Boseki Kabushiki Kaisha**
**Ohtsu-shi, Shiga 520-0292 (JP)**

(74) Representative: **Müller-Boré & Partner**
**Patentanwälte**
**Grafinger Strasse 2**
**81671 München (DE)**

(54) **ADHESIVE SHEET, METAL-LAMINATED SHEET AND PRINTED WIRING BOARD**

(57) The adhesive sheet contains a substrate film and an adhesive layer formed at least on one surface of the substrate film. The substrate film is made of a polyimide film showing a degree of curl after a heat treatment at 300˚C of not more than 10%. The adhesive sheet of the present invention can be used for electronic parts and the like exposed to high temperature particularly because warpage and distortion thereof caused by a high temperature treatment are suppressed, and can improve quality and yield of electronic parts and the like.

**FIG. 3**

EP 1 872 940 A1

## Description

### Technical Field

The present invention relates to an adhesive sheet, a metal-laminated sheet and a printed circuit board. More particularly, the present invention relates to an adhesive sheet used for forming an insulating layer for a printed circuit board and the like to be used for a flexible printed circuit substrate and the like aiming at down-sizing and reducing weight of electronic devices and electronic parts, a metal-laminated sheet wherein a metal foil is laminated on the adhesive sheet and a printed circuit board obtained by processing the metal-laminated sheet.

### Background Art

When an adhesive sheet or adhesive film is used for forming an insulating layer in a printed circuit board and the like, what is called a prepreg has been used, wherein a glass fiber cloth is impregnated with an uncured epoxy resin and the like. There has been used one comprising an aramid fiber cloth instead of a glass fiber cloth. Such prepregs have high thickness of the cloth and could not be made light weight and thin, despite the demand therefor in recent years.

In recent years, high functionalizing, high performance and down-sizing of electronic devices are being achieved, and down-sizing and lightening of the electronic parts used therefor are required. As a result, multi-layer printed circuit board, semiconductor element package, and wiring materials and wiring parts used for mounting them are also required to have higher density, higher function and higher property. There is a demand for a material superior in the heat resistance, electric reliability, adhesiveness and insulation property, which can be preferably used as a high density mounting material for semiconductor package, COL and LOC package, MCM and the like and as an FPC material for multi-layer flexible printed circuit board and the like.

Various proposals have been made to form an insulating layer on a printed circuit board and the like, and to achieve down-sizing and reduction of weight as a result of forming the insulating layer.

As insulating layers, use of various epoxy resins comparatively superior in heat resistance is known. However, it is associated with problems of nonuniformity, resin contamination and the like due to nonuniform flow and the like, and further, lack of reliability in insulation property due to high dielectric tangent.

In an attempt to solve the aforementioned problems, an adhesive film comprising a 50 $\mu$m-thick adhesive layer made of a resin from silicone copolymerized polyimide resin and epoxy resin, which is formed on a temporary support, has been proposed (JP-A-2003-089784). Also in this method, while the film is superior in the permeability in between the circuits (conductors), it cannot entirely solve the aforementioned problems and does not ensure a constant thickness of the insulating layer. Thus, the film has problems when an insulating layer is formed for a high frequency circuit board requiring strictly ensured characteristic impedance and the like.

In addition, use of a thermoplastic polyimide resin has been proposed (JP-A-2000-143981, JP-A-2000-144092, JP-A-2003-306649).

Furthermore, a film having an adhesive layer made of a thermoplastic polyimide and a thermosetting resin, which is formed on at least one surface of a polyimide film has been proposed (JP-A-2003-011308).

Furthermore, a polyimide elongated film having less curling at 25°C by setting the orientation ratio of the front and the back of the polyimide elongated film to a value not higher than a given value has also been proposed (JP-A-2000-085007).

### Disclosure of the Invention

Conventionally known substrate films made of a polyimide film or a polyimide benzoxazole film are inferior in heat resistance as compared to substrates made of ceramic. In addition, they have problem of easy occurrence of warpage and distortion during production of electronic parts due to property variation within the film. In addition, in an attempt to eliminate the warpage and distortion of a film, a measure to reduce apparent film warpage was employed by a heat treatment while stretching the film and the like. However, even if apparent film warpage, namely, exteriorized film warpage etc., could be eliminated, the problem of potential distortion that could be exteriorized by a treatment at a high temperature to cause curling, which treatment is particularly necessary for high temperature processing for the application of electronic parts, has not been solved. Accordingly, even if a film shows small apparent warpage, if it permits curling during processing, the yield of production decreases and high quality electronic parts are often difficult to obtain.

The present invention aims at provision of an adhesive sheet superior in the planarity and homogeneity, which is preferable as a substrate for electronic parts, which uses, as a substrate film, a polyimide film superior in heat resistance with less warpage and curling even after a treatment at a high temperature, a metal-laminated sheet wherein this adhesive sheet is laminated with a metal foil, and a printed circuit board wherein this metal-laminated sheet is processed to form a circuit.

The present inventors have conducted intensive studies and found that a polyimide film having a degree of curl at 300˚C of not more than 10% is used as a substrate film for an adhesive sheet, a metal-laminated sheet, and FPC (flexible printed circuit board), a TAB tape, a COF tape film and the like, a high quality and uniform FPC (flexible printed circuit board), TAB tape, COF tape film and the like can be obtained, which resulted in the completion of the present invention.

Accordingly, the present invention has the following constitution.

1. An adhesive sheet comprising, as a substrate film, a polyimide film having a degree of curl after a heat treatment at 300˚C of not more than 10%, and an adhesive layer formed on at least one surface of the substrate film.

2. The adhesive sheet of the above-mentioned 1, wherein the degree of curl after the heat treatment at 300˚C is not more than 8%.

3. The adhesive sheet of the above-mentioned 1 or 2, wherein the polyimide film is made of a polyimide obtained by reacting aromatic tetracarboxylic acid with aromatic diamine.

4. The adhesive sheet of the above-mentioned 3, wherein the polyimide comprises at least a pyromellitic acid residue as an aromatic tetracarboxylic acid residue, and at least a diaminodiphenyl ether residue as an aromatic diamine residue.

5. The adhesive sheet of the above-mentioned 4, further comprising a biphenyltetracarboxylic acid residue as an aromatic tetracarboxylic acid residue and a p-phenylenediamine residue as an aromatic diamine residue.

6. The adhesive sheet of the above-mentioned 3, wherein the polyimide comprises at least a biphenyltetracarboxylic acid residue as an aromatic tetracarboxylic acid residue, and at least a phenylenediamine residue as an aromatic diamine residue.

7. The adhesive sheet of any of the above-mentioned 1 - 6, wherein the adhesive constituting the adhesive layer is a thermosetting adhesive.

8. The adhesive sheet of any of the above-mentioned 1 - 6, wherein the adhesive constituting the adhesive layer is a thermoplastic adhesive.

9. A metal-laminated sheet wherein a metal foil is laminated on the adhesive layer of the adhesive sheet of any of the above-mentioned 1 - 8.

10. A printed circuit board comprising the metal-laminated sheet of the above-mentioned 9, wherein a part of the metal foil is removed.

11. A printed circuit board comprising a laminate of plural printed circuit boards of the above-mentioned 10.

12. A printed circuit board comprising the printed circuit board of the above-mentioned 10 or 11 and a semiconductor chip mounted thereon.

13. A semiconductor package comprising the printed circuit board of the above-mentioned 10 or 11 and a semiconductor chip mounted thereon.

**Brief Description of the Drawings**

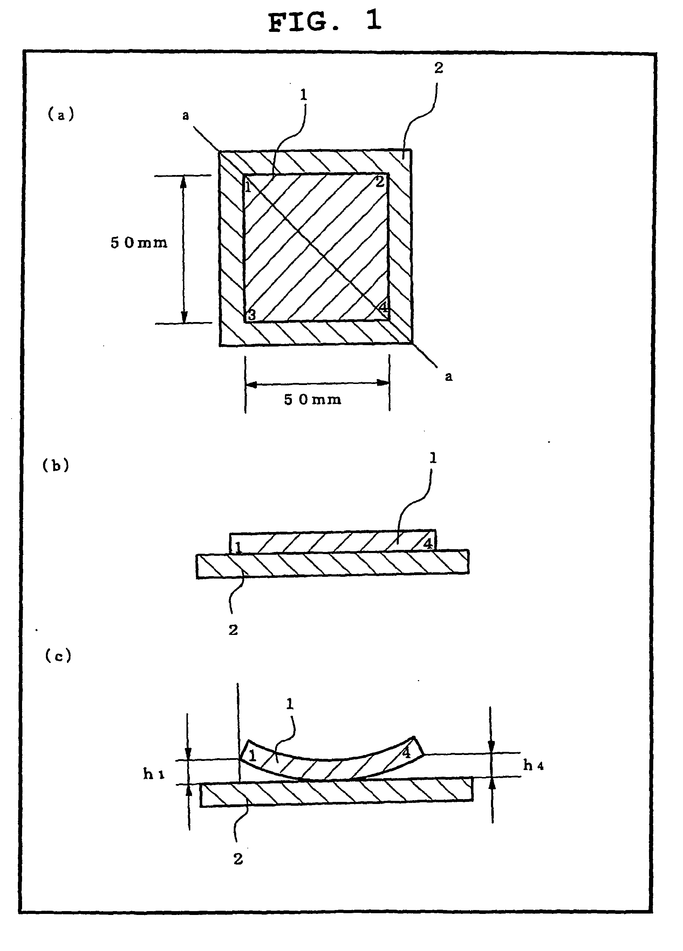

Fig. 1 is a schematic diagram showing the measurement method of the degree of curl of a polyimide elongated film, wherein (a) is a plane view, (b) is a sectional view along a-a of (a) before a hot air treatment, and (c) is a sectional view along a-a of (a) after the hot air treatment. In (c), various sheets are stood still during measurement of the degree of warpage of the various sheets. The hatching in (a) was applied to distinguish the regions of a test piece 1 and an alumina·ceramic plate 2.

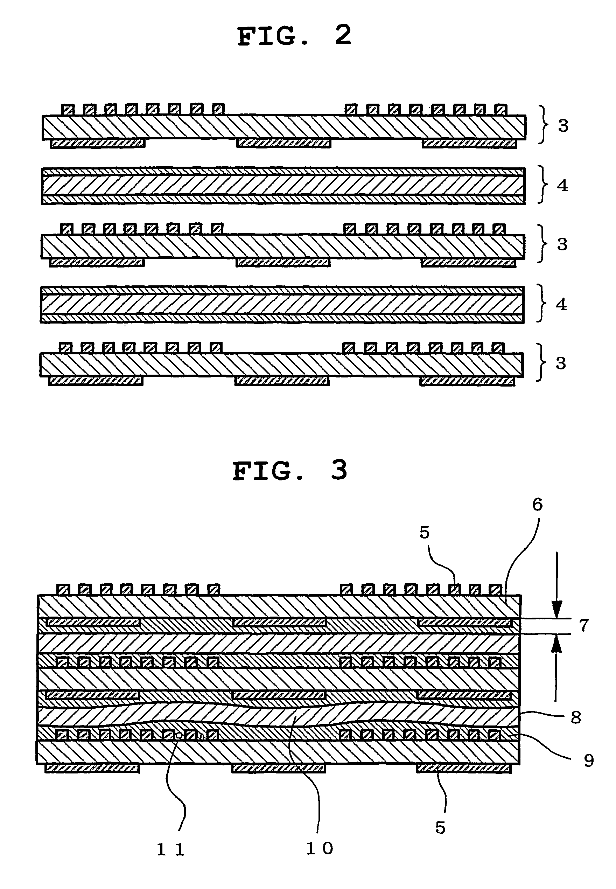

Fig. 2 is a schematic sectional view showing the constitution of a test circuit substrate before lamination, wherein symbol 3 shows a test circuit substrate and symbol 4 shows an adhesive sheet.

Fig. 3 is a schematic sectional view showing the constitution of a test circuit substrate after lamination when the adhesive sheet is deformed, wherein symbol 5 shows a copper foil, symbol 6 shows a polymer film on the circuit side, symbol 7 shows an insulating layer width, symbol 8 shows an adhesive sheet polymer film, symbol 9 shows an adhesive, symbol 10 shows film deformation, and symbol 11 shows a void.

**Best Mode for Embodying the Invention**

The adhesive sheet of the present invention is explained in the following.

The adhesive sheet of the present invention comprises a substrate film and an adhesive layer formed on at least one surface of the substrate film, which is first characterized in that the substrate film is composed of a polyimide film having a degree of curl after a heat treatment at 300˚C of not more than 10%.

In the present invention, the degree of curl at 300˚C for a polyimide film means the degree of deformation in the thickness direction relative to that in the surface direction of a film after a given heat treatment. Specifically, as shown in Fig. 1, a 50 mmx50 mm test piece 1 is treated with hot air at 300°C for 10 min, stood still on a flat plane (alumina·ceramic plate 2) to form a concave, an average distance from each top point on the test piece 1 to the flat plane (h1, h2, h3, h4: unit mm) is taken as the amount of curl (mm), and a value shown by the percentage (%) of the amount of curl relative to the distance (35.36 mm) from each top point on the test piece 1 to the center (midpoint of the diagonal line of the test piece 1) is obtained.

In the test piece 1, using 2 points (points at 1/3 and 2/3 of the length of the width) in the width direction at a pitch of 1/5 of the length of the polyimide film as the centers of the test piece, and samples are taken at a total of 10 points (n=10) (when not possible, sampled at the maximum of n points), where the measured value is an average of the 10 (or n) points.

Specifically, it is calculated by the following formula.

$$\text{amount of curl (mm)} = (h1+h2+h3+h4)/4$$

$$\text{degree of curl (\%)} = 100 \times (\text{amount of curl})/35.36$$

In the present invention, the degree of curl of polyimide film after a heat treatment at 300°C is not more than 10%, more preferably not more than 8%, still more preferably not more than 5%. When it exceeds 10%, the distortion contained in the film is expressed to allow development of curling during production of electronic parts using the polyimide film in the present invention as a substrate (particularly, step of soldering an electronic member to be treated at a high temperature), which in turn causes problems of misalignment in the position of electronic members, delamination and the like, thus possibly interrupting chassis assembly, connector connection and the like.

The substrate film is preferably made of a polyimide obtained by reacting aromatic tetracarboxylic acid with aromatic diamine. As polyimide, one comprising at least a pyromellitic acid residue as an aromatic tetracarboxylic acid residue, and at least a diaminodiphenyl ether residue as an aromatic diamine residue, or comprising at least a biphenyltetracarboxylic acid residue as an aromatic tetracarboxylic acid residue and at least a phenylenediamine residue as an aromatic diamine residue is preferable. It may comprise a pyromellitic acid residue and a biphenyltetracarboxylic acid residue as aromatic tetracarboxylic acid residues and a diaminodiphenyl ether residue and a phenylenediamine residue as aromatic diamine residues. The polyimide may have other aromatic tetracarboxylic acid residue and other aromatic diamine residue than those mentioned above.

In the present invention, the pyromellitic acid residue is a group derived from pyromellitic acid in polyamic acid or polyimide obtained by reacting pyromellitic acid, a functional derivative such as an anhydride thereof or a halide thereof and the like and aromatic diamine. The diaminodiphenyl ether residue is a group derived from diaminodiphenyl ether in polyamic acid or polyimide obtained by reacting diaminodiphenyl ether or various derivatives thereof and aromatic tetracarboxylic acid.

In the present invention, moreover, the biphenyltetracarboxylic acid residue is a group derived from biphenyltetracarboxylic acid in polyamic acid or polyimide obtained by reacting biphenyltetracarboxylic acid, a functional derivative such as an anhydride thereof or a halide thereof and the like and aromatic diamine. The phenylenediamine residue is a group derived from phenylenediamine in polyamic acid or polyimide obtained by reacting phenylenediamine or various derivatives thereof and aromatic tetracarboxylic acid. In the present invention, other aromatic tetracarboxylic acid residue, and other aromatic diamine residue both mean as defined above.

The aforementioned "reaction" is achieved by subjecting aromatic diamine and aromatic tetracarboxylic acid to a ring opening polyaddition reaction and the like in a solvent to give an aromatic polyamic acid solution, then forming a green film from the aromatic polyamic acid solution, which is followed by a heat treatment at a high temperature or dehydrating condensation (imidation).

The aromatic polyamic acid is produced by reacting or polymerizing substantially an equimolar amount of the above-mentioned aromatic tetracarboxylic acids (collectively referring to acid, anhydride, functional derivative, hereinafter to be also referred to as aromatic tetracarboxylic acid) with aromatic diamines (collectively referring to aromatic diamine, aromatic diamine derivative, hereinafter to be also referred to as aromatic diamine) preferably at a polymerization temperature of 90°C or below for one min to several days in an inert organic solvent. The aromatic tetracarboxylic acid and aromatic diamine may be directly added in the form of a mixture or added as a solution to the organic solvent, or the organic solvent may be added to the above-mentioned mixture.

The organic solvent only need to dissolve a part or the whole of the polymerization components, and preferably dissolves a copolyamic acid polymer.

Preferable solvents include N,N-dimethylformamide and N,N-dimethylacetamide. Of this kind of solvents, other useful solvents are N,N-diethylformamide and N,N-diethylacetamide. As other usable solvents, dimethyl sulfoxide, N-methyl-2-pyrrolidone, N-cyclohexyl-2-pyrrolidone and the like can be mentioned. The solvents can be used alone or in a combination of two or more thereof or in a combination with a poor solvent such as benzene, benzonitrile, dioxane and the like.

The amount of the solvent to be used is preferably within the range of 75 - 90 mass % of the aromatic polyamic acid solution. This concentration range affords the optimal molecular weight. It is not necessary to use the aromatic tetracarboxylic acid component and the aromatic diamine component absolutely in an equimolar amount. To adjust the molecular weight, the molar ratio of aromatic tetracarboxylic acid/aromatic diamine is within the range of 0.90 - 1.10.

The aromatic polyamic acid solution produced as mentioned above contains 5 - 40 mass %, preferably 10 - 25 mass %, of a polyamic acid polymer.

In the present invention, diaminodiphenyl ether and phenylenediamine are preferable diamines from among the aromatic diamines. Specific examples of diaminodiphenyl ether include 4,4'-diaminodiphenyl ether (DADE), 3,3'-diaminodiphenyl ether and 3,4'-diaminodiphenyl ether. Specific examples of phenylenediamine include p-phenylenediamine, o-phenylenediamine and m-phenylenediamine, and p-phenylenediamine can be preferably used.

In a preferable embodiment, phenylenediamines (preferably p-phenylenediamine) can be used in addition to diaminodiphenyl ether. Moreover, other aromatic diamine may be appropriately selected and used in addition to these aromatic diamines.

In the present invention, pyromellitic acids (pyromellitic acid, dianhydride thereof (PMDA) and lower alcohol esters thereof), and biphenyltetracarboxylic acids (biphenyltetracarboxylic acid, its dianhydride (BMDA) and lower alcohol esters thereof) are preferable from among the aromatic tetracarboxylic acids. As the biphenyltetracarboxylic acids, 3,3', 4,4'-biphenyltetracarboxylic acids are preferable.

In a preferable embodiment, biphenyltetracarboxylic acids (preferably 3,3',4,4'-biphenyltetracarboxylic acids) can be used in addition to pyromellitic acid. Moreover, other aromatic tetracarboxylic acids may be appropriately selected and used in addition to these aromatic tetracarboxylic acids.

In the present invention, phenylenediamines are preferably used in a proportion of 50 - 100 mol% relative to the whole aromatic diamines, aromatic diamine other than phenylenediamines is preferably used in a proportion of 0 - 50 mol% relative to the whole aromatic diamines, and diamines other than the two above are preferably used in a proportion of 0 - 50 mol% relative to the whole aromatic diamines. Moreover, diaminodiphenyl ethers may be used in a proportion of 50 - 100 mol% relative to the whole aromatic diamines, phenylenediamines may be used in a proportion of 0 - 50 mol% relative to the whole aromatic diamines, and aromatic diamines other than the two above may be used in a proportion of 0 - 50 mol% relative to the whole aromatic diamines. When the mol% ratio thereof exceeds this range, a heat resistant polyimide film unpreferably shows imbalanced flexibility, rigidity, strength, elastic modulus, water absorption coefficient, hygroscopic expansion coefficient, elongation and the like.

In the present invention, biphenyltetracarboxylic acid anhydride is preferably used in a proportion of 50 - 100 mol% relative to the whole aromatic tetracarboxylic acids, aromatic tetracarboxylic acid other than biphenyltetracarboxylic acids is preferably used in a proportion of 0 - 50 mol% relative to the whole aromatic tetracarboxylic acids, and aromatic tetracarboxylic acids other than the two above are preferably used in a proportion of 0 - 50 mol% relative to the whole aromatic tetracarboxylic acids. Moreover, pyromellitic acids may be used in a proportion of 50 - 100 mol% relative to the whole aromatic tetracarboxylic acids, biphenyltetracarboxylic acids (preferably 3,3',4,4'-biphenyltetracarboxylic acid anhydride) may be used in a proportion of 0 - 50 mol% relative to the whole aromatic tetracarboxylic acids, and aromatic tetracarboxylic acids other than the two above may be used in a proportion of 0 - 50 mol% relative to the whole aromatic tetracarboxylic acids. When the mol% ratio thereof exceeds this range, a heat resistant polyimide film unpreferably shows imbalanced flexibility, rigidity, strength, elongation, elastic modulus, water absorption coefficient, hygroscopic expansion coefficient and the like.

While those usable besides the aforementioned aromatic diamines and aromatic tetracarboxylic acids are not particularly limited, for example, the following can be recited as examples.

Examples of aromatic diamine other than those mentioned above include 5-amino-2-(p-aminophenyl)benzoxazole, 6-amino-2-(p-aminophenyl)benzoxazole, 5-amino-2-(m-aminophenyl)benzoxazole, 6-amino-2-(m-aminophenyl)benzoxazole, 4,4'-bis(3-aminophenoxy)biphenyl, bis[4-(3-aminophenoxy)phenyl]ketone, bis[4-(3-aminophenoxy)phenyl]sulfide, bis[4-(3-aminophenoxy)phenyl]sulfone, 2,2-bis[4-(3-aminophenoxy)phenyl]propane, 2,2-bis[4-(3-aminophenoxy)phenyl]-1,1,1,3,3,3-hexafluoropropane, 3,3'-diaminodiphenylsulfide, 3,3'-diaminodiphenylsulfoxide, 3,4'-diaminodiphenylsulfoxide, 4,4'-diaminodiphenylsulfoxide, 3,3'-diaminodiphenylsulfone, 3,4'-diaminodiphenylsulfone, 4,4'-diaminodiphenylsulfone, 3,3'-diaminobenzophenone, 3,4'-diaminobenzophenone, 4,4'-diaminobenzophenone, 3,3'-diaminodiphenylmethane, 3,4'-diaminodiphenylmethane, 4,4'-diaminodiphenylmethane, bis[4-(4-aminophenoxy)phenyl]methane, 1,1-bis[4-(4-aminophenoxy)phenyl]ethane, 1,2-bis[4-(4-aminophenoxy)phenyl]ethane, 1,1-bis[4-(4-aminophenoxy)phenyl]propane, 1,2-bis[4-(4-aminophenoxy)phenyl]propane, 1,3-bis[4-(4-aminophenoxy)phenyl]propane, 2,2-bis[4-(4-aminophenoxy)phenyl]propane and the like.

Examples thereof include aromatic diamine wherein a part or the whole of hydrogen atom on the aromatic ring in the above-mentioned aromatic diamine is substituted by halogen atom, an alkyl group or alkoxyl group having 1 to 3 carbon atoms, a cyano group, or a halogenated alkyl group or alkoxyl group having 1 to 3 carbon atoms, wherein a part or the whole of hydrogen atom of alkyl group or alkoxyl group is substituted by halogen atom, and the like.

Examples of aromatic tetracarboxylic acids other than those mentioned above include bisphenol A bis(trimellitic acid monoester acid anhydride), 2,2-bis[4-(3,4-dicarboxyphenoxy)phenyl]propanoic acid anhydride, 3,3',4,4'-benzophenonetetracarboxylic acid dianhydride, 3,3',4,4'-diphenylsulfonetetracarboxylic acid dianhydride, 1,4,5,8-naphthalenetetracarboxylic acid dianhydride, 2,3,6,7-naphthalenetetracarboxylic acid dianhydride, 4,4'-oxydiphthalic acid anhydride, 3,3',4,4'-dimethyldiphenylsilane tetracarboxylic acid dianhydride, 1,2,3,4-furantetracarboxylic acid dianhydride, 4,4'-bis (3,4-dicarboxyphenoxy)diphenylpropanoic acid dianhydride, 4,4'-hexafluoroisopropylidenediphthalic acid anhydride and the like.

A method of producing a polyimide film to be used in the present invention, which shows a degree of curl after a heat treatment at 300°C of not more than 10% is not particularly limited. In a preferable production example, a polyimide precursor film (green film) is produced, which satisfies the imidation rate $IM_A$ of one surface side (surface A side) and imidation rate $IM_B$ of the other surface side (surface B side) of the polyimide precursor film (green film), as shown by the following formula, and the polyimide precursor film (green film) is imidated.

$$\text{Formula 1;} \quad |IM_A - IM_B| \leq 5$$

In the present invention, the imidation rate of the green film is measured by the following method.

<Measurement method of imidation rate>

A 2 cmx2 cm measurement target film is taken, the measurement target surface is closely adhered to ATR crystal, and set on an IR measurement apparatus. The absorbance at the following characteristic wavelength is measured and the imidation rate of the measured film target surface is obtained by the following formula.

As the imide characteristic wavelength, around 1778 cm$^{-1}$ is employed and the absorbance of the measured surface at the wavelength is taken as $\lambda_{1778}$. As the standard, the aromatic ring characteristic wavelength of around 1478 cm$^{-1}$ is employed and the absorbance of the measured surface at the wavelength is taken as $\lambda_{1478}$.

apparatus; FT-IR FTS60A/896 (Digilab Japan Co., Ltd.) measurement condition; one reflection ATR attachment (SILVER GATE)

ATR crystal Ge
incident angle 45°
detector DTGS
resolution 4 cm$^{-1}$
accumulation time 128 times
Formula 2; IM={Iλ/I(450)}x100

In Formula 2, $I\lambda = (\lambda_{1778}/\lambda_{1478})$, and 1(450) is the value of $(\lambda_{1778}/\lambda_{1478})$ when a polyimide precursor film having the same composition is imidated by thermal cyclization at 450°C for 15 min and the resulting film is measured in the same manner.

These values can be measured from formula 2 using the imidation rate IM of surface A as $IM_A$, and that of surface B as $IM_B$. The difference between $IM_A$ and $IM_B$ is shown in an absolute value.

The measurement points are any points in the longitudinal direction of the film, which are two points in the width direction (points at 1/3 and 2/3 of beam length), and the measured value is an average of the two points.

While the method for producing the above-mentioned particular green film is not particularly limited, a preferable example is the following method.

When the green film is dried to the degree it acquires self-supporting property, the direction of evaporation of the solvent is limited to the surface in contact with the air. As a result, the imidation rate of the surface of the green film in contact with the air tends to become smaller than that of the surface in contact with the support. To obtain a polyimide film showing a small difference in the orientation between the front and the back surfaces, the difference in the imidation rate between the front and the back surfaces of the green film needs to be within a tolerance range. The imidation rate of the green film becomes high when a thermal energy is applied more than necessary when the amount of solvent is high and the degree of freedom of polyamic acid molecule is high. To suppress the difference in the imidation rate between the front and the back to a tolerance range, it is necessary to remove the solvent as uniformly as possible from the front and the back with the minimum necessary heating. Thus, the drying conditions for obtaining a self-supporting green film by coating a support with a polyamic acid solution and drying same need to be controlled while managing the amount of heat to be added, evaporation rate of solvent, difference in the solvent amount between the front and the back and the like. By such control, a green film wherein the imidation rates of the front and the back surfaces are within a given range and the difference between them is within a given range can be obtained.

The difference in the imidation rate between the front and the back surfaces of the green film is preferably not more than 5, more preferably not more than 4, still more preferably not more than 3. Moreover, the imidation rate of both the front and the back is preferably controlled to fall within the range of 1 - 15.

When the difference in the imidation rate between the front and the back surfaces of the green film exceeds 5, the distortion potentially present within the film remains, and curling is developed after a heat treatment at 300˚C, affording a polyimide elongated film unsuitable for production.

In addition, a green film wherein the imidation rates of the front and the back surfaces are within a given range and the difference between them is within a given range can be obtained by controlling the residual solvent amount relative to the total mass of the green film after drying, when the coated film is dried to the extent that the green film acquires self-supporting property. To be specific, the residual solvent amount relative to the total mass of the green film after drying is essentially preferably 25 - 50 mass %, more preferably 35 - 50 mass %. When the residual solvent amount is lower than 25 mass %, the imidation rate on one side of the green film becomes relatively too high, making it difficult to obtain a green film showing a small difference in the imidation rate between the front and the back surfaces, but also the green film tends to be brittle due to the lower molecular weight. When it exceeds 50 mass %, the self-supporting property becomes insufficient, making transport of the film difficult.

To achieve such conditions, a dryer such as hot air, hot nitrogen, far-infrared radiation, high frequency induction heating and the like can be used. As the drying conditions, the following temperature control is required.

When hot air drying is performed, during drying of the coated film to the extent that the green film has self-supporting property, an operation allowing uniform volatilization of the solvent from the entirety of the coated film by prolonging the constant rate of drying conditions is preferable, so that the imidation rate of the front and the back surfaces of the green film and the difference thereof can be set within the given ranges. The constant rate of drying is a drying region where the coated film surface is made of a free liquid level and volatilization of the solvent is controlled by the movement of substance in the outside world. Under the drying conditions where the coated film surface is solidified by drying, and solvent diffusion in the coated film becomes a rate determining factor, the property of the front and the back easily becomes different. While such preferable drying state varies depending on the kind and thickness of the support, the coated film is dried under the conditions of temperature setting and air amount setting where the ambient temperature of the opposite side (opposite surface side of the coated film surface) to the upper side (coated film surface side) of the coated film (green film) on a support is generally higher by 1 - 55˚C than the ambient temperature of the upper side (coated film surface side) of the coated film (green film) on a support. In the explanation of the ambient temperature, the direction heading from the coated film toward the support is defined as a lower direction, and the opposite is defined as an upper direction. Such description of the upper and lower directions aims at a simply expression of the positions of the regions to be noted, and does not intend to specify the absolute direction of the coated film in the actual production.

The "ambient temperature of the coated film surface side" is a temperature of the region from the surface of the coated film to 30 mm above the coated film surface (generally a space), and the ambient temperature of the coated film surface side can be determined by measuring the temperature with a thermocouple and the like at the position 5 - 30 mm away in the upward direction from the coated film.

The "ambient temperature of the opposite side" is a temperature of the region from immediately beneath the coated film (support) to 30 mm below the coated film (often containing support and a part under the support), and the ambient temperature of the opposite side can be determined by measuring the temperature with a thermocouple and the like at the position 5 - 30 mm away in the downward direction from the coated film.

When the ambient temperature of the opposite surface side is set higher by 1 - 55˚C than that of the coated film surface side during drying, a high quality film can be obtained even when the drying temperature itself is made higher to increase the drying rate of the coated film. When the ambient temperature of the opposite surface side is lower than that of the coated film surface side, or the difference in the ambient temperature of the coated film surface side from that on the opposite side is less than 1˚C, the vicinity of the coated film surface is dried earlier to form a film like a "lid", which prevents transpiration of the solvent to be evaporated from the vicinity of the support, producing a fear of inducing a distortion in the inside structure of the film. It is economically disadvantageous and undesirable for the apparatus that the ambient temperature of the opposite side is set higher than that of the coated film surface side and the temperature difference is set greater than 55˚C. Preferably, during drying, the ambient temperature of the aforementioned opposite side is set higher by 5 - 55˚C, more preferably 10 - 50˚C, further preferably 15 - 45˚C, than that of the coated film surface side.

The ambient temperature of the coated film surface side is specifically preferably 80 - 105˚C, more preferably 90 - 105˚C.

The ambient temperature on the opposite side is specifically preferably 85˚C - 105˚C, more preferably 100 - 105˚C.

The above-mentioned setting of the ambient temperature may be performed throughout the entire drying steps of the coated film, or in a part of the drying steps of the coated film. When the coated film is dried in a continuous dryer such as a tunnel furnace and the like, the aforementioned ambient temperature only needs to be set for the length of preferably 10 - 100%, more preferably 15 - 100%, of a drying effective length.

The drying time is 10 - 90 min, desirably 15 - 45 min, in total. The heating temperature is preferably 80 - 125˚C, more preferably 85 - 105˚C, from the aspects of prevention of inconveniences due to warpage, distortion and the like.

The green film after the drying step is then subjected to an imidation step, which may be performed by any of inline and offline methods.

When an offline is employed, the green film is once wound up. In this case, the film is wound around a tubular object with the green film facing inside (support being the outside) to reduce curling.

In any event, the film is preferably transported or wound in such a manner that the radius of curvature will not become 30 mm or below.

In the present invention, the "precursor film (green film)" is a film wherein the amount of the residual solvent is about 50 mass % or below, though subject to change depending on the thickness and molecular weight, which is specifically a film obtained by drying the coated film on the support, and refers to a film between release from the support and heating to not less than 50˚C. When the atmosphere for releasing is already not less than 50˚C, it refers to a film between immediately after release and heating to not less than release ambient temperature+30˚C.

By imidation of a green film obtained by such method, wherein the imidation rate of the front and the back surfaces and the difference therein has been controlled to fall within given ranges under given conditions, a polyimide elongated film having a low degree of curl after a heat treatment at 300˚C of the present invention can be obtained.

As specific imidation method therefor, a conventionally-known imidation reaction can be appropriately used. For example, a method comprising subjecting a polyamic acid solution free of a cyclization catalyst and a dehydrating agent to a heat treatment to carry out an imidation reaction (what is called a thermal cyclization method) and a chemical cyclization method wherein a cyclization catalyst and a dehydrating agent are added to a polyamic acid solution and an imidation reaction is performed by the action of the above-mentioned cyclization catalyst and dehydrating agent can be mentioned, of which the thermal cyclization method is preferable for affording a polyimide elongated film showing a degree of curl after a heat treatment at 300˚C of 10% or below.

The maximum temperature of heating by the thermal cyclization method is, for example, 100 - 500˚C, preferably 200 - 480˚C. When the maximum heating temperature is lower than this range, sufficient cyclization becomes difficult, and when it is higher than this range, degradation proceeds and the film tends to be brittle. A more preferable embodiment is a two-step heat treatment including a treatment at 150 - 250˚C for 3 - 20 min, followed by a treatment at 350 - 500˚C for 3 - 20 min.

In the chemical cyclization method, a polyamic acid solution is applied to a support, an imidation reaction is partially carried out to form a film having self-supporting property, and the imidation is sufficiently carried out by heating. In this case, the conditions for partial progress of imidation reaction include a heat treatment preferably at 100 - 200˚C for 3 - 20 min, and the conditions for sufficiently carrying out imidation reaction include a heat treatment preferably at 200 - 400˚C for 3 - 20 min.

The both ends of the film are held with a pin tenter or clip during the aforementioned drying treatment and imidation treatment. During this operation, the tension in the width direction and the longitudinal direction of the film is desirably maintained as uniformly as possible to retain the uniformity of the film.

Specifically, immediately before subjecting the film to a pin tenter, the both ends of the film may be pressed with a brush to uniformly stick pins into the film. A rigid, heat-resistant fiber brush is desirable, and a high strength high elastic modulus monofilament can be used.

By satisfying the aforementioned conditions (temperature, time, tension) for the imidation treatment, the development of the orientation distortion in the film inside (front and back, flat plane direction) can be suppressed.

The timing of the addition of a cyclization catalyst to a polyamic acid solution is not particularly limited and it may be added in advance before a polymerization reaction to afford polyamic acid. Specific examples of the cyclization catalyst include aliphatic tertiary amines such as trimethylamine, triethylamine and the like, heterocyclic tertiary amine such as isoquinoline, pyridine, beta-picoline and the like, and the like. Of these, at least one kind of amine selected from heterocyclic tertiary amines is preferable. While the amount of the cyclization catalyst to be used relative to 1 mol of polyamic acid is not particularly limited, it is preferably 0.5 - 8 mol.

The timing of the addition of a dehydrating agent to a polyamic acid solution is not particularly limited either, and it may be added in advance before a polymerization reaction to afford polyamic acid. Specific examples of the dehydrating agent include aliphatic carboxylic acid anhydrides such as acetic anhydride, propionic anhydride, butyric anhydride and the like, aromatic carboxylic acid anhydrides such as benzoic anhydride and the like, and the like. Of these, acetic anhydride, benzoic anhydride and a mixture thereof are preferable. While the amount of the dehydrating agent to be used per 1 mol of polyamic acid is not particularly limited, it is preferably 0.1 - 4 mol. When a dehydrating agent is to be used, a gelling retardant such as acetylacetone and the like may be used in combination.

Whether the thermal cyclization reaction or the chemical cyclization method, a precursor (green sheet, film) of polyimide elongated film formed on a support may be released from the support before sufficient imidation, or after the imidation.

While the thickness of the polyimide elongated film is not particularly limited, it is generally 1 - 150 $\mu$m, preferably 3 - 50 $\mu$m, in consideration of its use for an electronic substrate such as a base substrate for the below-mentioned printed circuit substrate and the like. The thickness can be easily controlled by changing the amount of the polyamic acid solution to be applied to the support and the concentration of the polyamic acid solution.

It is preferable to improve slip property of a polyimide film as a substrate in the present invention by adding a lubricant to polyimide to form ultrafine concaves and convexes on the film surface, and the like.

As the lubricant, inorganic and organic fine particles having an average particle size of about 0.03 - 3 $\mu$m can be used. Specific examples include titanium oxide, alumina, silica, calcium carbonate, calcium phosphate, calcium hydrogenphosphate, calcium pyrophosphate, magnesium oxide, calcium oxide, clay mineral and the like.

In the polyimide elongated film obtained by the above-mentioned production method, a polyimide elongated film having a smaller degree of curl can be preferably obtained by winding the film around a tubular object with surface A facing inside, which tends to show a greater absorption ratio than surface B. In the present invention, surface A refers to a surface having a higher absorption ratio and surface B refers to a surface having a smaller absorption ratio. For winding the film around a tubular object with surface A facing inside, the radius of curvature thereof is preferably within the range of from 30 mm to 600 mm. When the radius of curvature exceeds this range, the degree of curl of the polyimide elongated film sometimes becomes high.

The aforementioned absorption ratio means an orientation degree of the imide ring plane of polyimide molecules, which are in the depth of about 3 $\mu$m down from the film surface (or backside, hereinafter the same), relative to the film surface. Specifically, polarized ATR measurement of the film surface is performed by FT-IR (measurement apparatus: FTS-60A/896 manufactured by Digilab, etc.) under the conditions of one-time reflection ATR attachment, golden gate MkII (manufactured by SPECAC LIMITED), IRE diamond, incident angle 45˚, resolution 4 cm$^{-1}$ and accumulation time 128 times, the absorption coefficients (Kx, Ky and Kz) of each direction at the peak (aromatic ring vibration) appearing near 1480 cm$^{-1}$ are determined and the ratio is defined by the following formula.

$$\texttt{absorption ratio=(Kx+Ky)/2×Kz}$$

wherein Kx shows an absorption coefficient in the MD direction, Ky shows an absorption coefficient in the TD direction, and Kz shows an absorption coefficient in the thickness direction.

The measurement position is an optional position in the longitudinal direction of the film. In this case, two points in the width direction (points 1/3 and 2/3 of the beam length), and the measured value is an average of the two points.

Furthermore, the winding tension is desirably set to not less than 100 N, preferably not less than 150 N and not more than 500 N.

Accordingly, a preferable embodiment for improving the curl when winding a polyimide elongated film around a roll may be a method comprising winding with surface A facing inside, wherein the radius of curvature is comparatively large and is 30 - 600 mm, preferably 80 - 300 mm, and further, the winding tension is not less than 100 N.

To reduce the difference in the property of the wound film between the winding core side (roll inner layer side) and the outward winding side (roll outer layer side) as much as possible, it is desirable to increase the winding tension as the radius of curvature of the film increases (making the winding tension on the winding core side smaller and that of the outward winding side greater).

Furthermore, when the imidation of the green film is to be performed offline, a method comprising winding the green film facing inside (support being outside) can be employed.

The polyimide elongated film is treated with heat in the drying step and imidation step of the green film. In this event, when the width direction of the film has treatment unevenness, the property changes in the width direction of the film, which in turn causes curling.

In the present invention, therefore, the difference in the ambient temperature in the width direction in a dryer is desirably controlled to central temperature $\pm$ within 5˚C, preferably $\pm$ within 3˚C, more preferably $\pm$ within 2˚C.

As used herein, the ambient temperature means a temperature measured using a thermocouple, thermolabel and the like at positions which are at the same distance (5 mm - 30 mm) away from the surface of the support. In the present invention, moreover, it is preferable to set 8 to 64 points of temperature detection end in the width direction.

Particularly, the interval between the neighboring detection ends in the width direction is preferably set to about 5 cm - 10 cm. As the detection end, a known thermocouple such as alumel-chromel and the like can be used.

In the present invention, the ambient temperature on the opposite side can be set 1 - 55˚C, preferably 5 - 55˚C higher than that on the coated surface side. Also in this case, it is essential to fall within the range of $\pm 5°$C from the central temperature of the temperatures on each side of the support. The central temperature is the arithmetic mean value of the centigrade temperatures measured at respective detection ends, and when the temperatures measured at respective detection ends in the width direction orthogonal to the running direction of the support are within the range of $\pm 5°$C, it is within the range calculated based on the numerical value of the central value.

The polyimide elongated film produced under such conditions is extremely superior in the planarity at a high temperature and shows a degree of curl of 10% or below as measured under the aforementioned conditions.

The adhesive sheet of the present invention is basically made of a polyimide film (IF) as a substrate, which is made of polyimide comprising an aromatic diamine residue and an aromatic tetracarboxylic acid residue, and which has a degree of curl after a heat treatment at 300°C of not more than 10%, and an adhesive layer formed on at least one surface of the substrate film. As the polyimide, one having at least a pyromellitic acid residue and a diaminodiphenyl ether residue, or one having at least a biphenyltetracarboxylic acid residue and a phenylenediamine residue is preferable, which may have a pyromellitic acid residue, a biphenyltetracarboxylic acid residue, a diaminodiphenyl ether residue and a phenylenediamine residue. The aforementioned adhesive layer is preferably formed from an adhesive selected from a thermosetting adhesive and a thermoplastic adhesive. The adhesive sheet of the present invention can also be used for forming an insulator layer between printed circuit boards and the like.

The thermosetting adhesive to be used in the present invention is not particularly limited as long as it is heat-curable and superior in the heat resistance and adhesiveness. However, the tensile elastic modulus of the adhesive is preferably smaller than that of the substrate. The tensile elastic modulus of the adhesive/tensile elastic modulus of substrate (ratio of tensile elastic modulus) is preferably 0.01 - 0.5, more preferably not more than 0.3, particularly preferably not more than 0.1.

When the tensile elastic modulus of the thermosetting adhesive is higher than that of the substrate film, the stress distortion of the substrate film and the metal foil having distant linear expansion coefficients cannot be easily relieved and absorbed by the adhesive layer. As a result, the connection reliability between semiconductor and metal foil layer tends to be not sufficiently expressed.

As the thermosetting adhesive to be used in the present invention, epoxy, urethane, acrylic, silicone, polyester, imide, polyamideimide and the like can be used. More particularly, for example, one containing a flexible resin such as polyamide resin and the like and a hard material such as phenol and the like as main components, and further containing epoxy resin, imidazole and the like can be used. More specifically, a suitable mixture of a dimer acid-based polyamideimide resin, phenol which is solid at romom temperature, epoxy which is liquid at romom temperature, and the like, and the like can be used. As a result, appropriate softness, hardness, adhesiveness and the like, as well as semi-hard state can be easily controlled. As the polyamideimide resin, one having a weight average molecular weight of 5000 - 100000 is preferable. Furthermore, since coagulation of amideimide resin varies due to carboxylic acid and amine, which are the starting materials of polyamideimide resin, it is preferable to appropriately select the molecular weight, softening point and the like of phenol and epoxy resin. In addition, polyamide resin, polyester resin, acrylonitrile butadiene resin, polyimide resin, butyral resin and the like can be used instead of polyamideimide resin. Furthermore, these materials after silicone-modification and the like are more preferable since they express flexibility.

In addition to phenol resin and epoxy resin, maleimide resin, resol resin, triazine resin and the like can also be used. It is also possible to add or copolymerize nitrile butadiene rubber and the like.

While the cured state of the thermosetting adhesive in the present invention can be controlled to a semi-cured state, as a method for controlling the cured state, for example, heating with warm air, heating by far-/near-infrared radiation, irradiation of electron beam and the like, for drying an adhesive applied on a substrate can be mentioned. For control by heating, heating at 100 - 200°C for 1 - 60 min is preferable, heating at 130 - 160°C for 5 - 10 min is more preferable. In addition, the cured state of FPC or a TAB tape wound in a roll can also be controlled by a heat treatment at a comparatively low temperature of, for example, about 40 - 90°C for a few hours - several hundred hours. The conditions under which to control cured state are preferably determined in consideration of the composition, curing mechanism and curing rate of adhesive. By controlling the cured state in this way, a semi-cured state adhesive can be obtained.

The thermosetting adhesive in the present invention is used after once becoming a semi-cured state. As used herein, by the semi-cured state is meant a solid phase state permitting softening or melting by heating and finally being cured. The thermosetting adhesive in the present invention contains a component basically affording flexibility and a component affording heat resistance, so that a semi-cured state can be maintained.

On the other hand, a thermoplastic adhesive to be used in the present invention is not particularly limited as long as it is thermoplastic or thermocompression bonding and superior in heat resistance and adhesiveness. It preferably shows a tensile elastic modulus of an adhesive smaller than that of a substrate. The tensile elastic modulus of the adhesive/tensile elastic modulus of substrate (ratio of tensile elastic modulus) is preferably 0.01 - 0.5, more preferably not more than 0.3, particularly preferably not more than 0.1.

When the tensile elastic modulus of the thermoplastic adhesive is higher than that the substrate film, the stress distortion of the substrate film and the metal foil having distant linear expansion coefficients cannot be easily relieved and absorbed by the adhesive layer. As a result, the connection reliability between semiconductor and metal foil layer tends to be not sufficiently expressed.

In the present invention, as a thermoplastic adhesive, thermoplastic polyimide, polyamideimide, whole aromatic polyester, polyetherimide, and polyamide resin can be used.

As a preferable thermoplastic adhesive in the present invention, an adhesive made of a thermoplastic (thermocompression bonding) polyimide resin can be mentioned from the aspects of heat resistance, adhesiveness with a film, and the like. The thermoplastic (thermocompression bonding) polyimide resin need only be a thermoplastic polyimide resin capable of thermocompression bonding at a temperature of about 230 - 400˚C. As a preferable thermocompression bonding polyimide, a polyimide obtained from, as a diamine, at least one kind of diamine selected from

APB :1,3-bis(3-aminophenoxybenzene),
m-BP :4,4'-bis(3-aminophenoxy)biphenyl,
DABP :3,3'-diaminobenzophenone,
DANPG:1,3-bis(4-aminophenoxy)-2,2-dimethylpropane, and as a tetracarboxylic acid anhydride, at least one kind of tetracarboxylic acid dianhydride selected from
PMDA :pyromellitic acid dianhydride,
ODPS :3,3',4,4'-diphenylethertetracarboxylic acid dianhydride,
BTDA :3,3',4,4'-benzophenonetetracarboxylic acid dianhydride,
BPDA :3,3',4,4'-biphenyltetracarboxylic acid dianhydride
α-BPDA:2,3,3',4'-biphenyltetracarboxylic acid dianhydride,
ODPA :4,4'-oxydiphthalic acid dianhydride, can be used. They may be used alone or in a combination of two or more kinds thereof. Furthermore, other diamines or tetracarboxylic acid anhydrides exemplified earlier can be used concurrently within the range not exceeding 50 mol% of each of diamines and tetracarboxylic acid anhydrides.

In the present invention, preferably shown are polyimide obtained from 1,3-bis(4-aminophenoxybenzene) and 2,3,3',4'-biphenyltetracarboxylic acid dianhydride, polyimide obtained from 1,3-bis(4-aminophenoxybenzene) and pyromellitic acid dianhydride, polyimide produced from 1,3-bis(4-aminophenoxy)-2,2-dimethylpropane and 4,4'-oxydiphthalic acid dianhydride (ODPA), polyimide obtained from 4,4'-oxydiphthalic acid dianhydride (ODPA) and pyromellitic acid dianhydride and 1,3-bis(4-aminophenoxybenzene), polyimide obtained from 1,3-bis(3-aminophenoxy)benzene and 3,3',4,4'-benzophenonetetracarboxylic acid dianhydride, and polyimide obtained from 3,3'-diaminobenzophenone and 1,3-bis(3-aminophenoxy)benzene and 3,3',4,4'-benzophenonetetracarboxylic acid dianhydride.

The reaction molar ratio of a diamine component and tetracarboxylic acid dianhydride is generally within the range of 0.75 - 1.25 mol of a tetracarboxylic acid dianhydride component relative to 1 mol of a diamine component. It is preferably within the range of 0.8 - 1.2 mol.

In the present invention, a dicarboxylic acid anhydride may be added to block the polymer end of a thermoplastic polyimide relating to a thermoplastic polyimide layer as a thermoplastic adhesive. As usable dicarboxylic acid anhydride, phthalic anhydride, 2,3-benzophenonedicarboxylic acid anhydride, 3,4-benzophenonedicarboxylic acid anhydride, 2,3-dicarboxyphenylphenylether anhydride, 2,3-biphenyldicarboxylic acid anhydride, 3,4-biphenyldicarboxylic acid anhydride, 2,3-dicarboxyphenylphenylsulfone anhydride, 3,4-dicarboxyphenylphenylsulfone anhydride, 2,3-dicarboxyphenylphenylsulfide anhydride, 1,2-naphthalenedicarboxylic acid anhydride, 2,3-naphthalenedicarboxylic acid anhydride, 1,8-naphthalenedicarboxylic acid anhydride, 1,2-anthracenedicarboxylic acid anhydride, 2,3-anthracenedicarboxylic acid anhydride, and 1,9-anthracenedicarboxylic acid anhydride can be mentioned.

These dicarboxylic acid anhydrides are optionally substituted by a group with no reactivity with amine or dicarboxylic acid anhydride. The amount of dicarboxylic acid anhydride to be added is generally within the range of 0.001 - 0.5 mol relative to the total amount 100 mol of the aforementioned particular diamine and tetracarboxylic acid dianhydride, which are the main starting materials. Preferably, it is within the range of 0.005 - 0.25 mol.

Similarly, monoamine may be added to block the polymer end of a thermoplastic polyimide. As the usable monoamine, for example, aniline, o-toluidine, m-toluidine, p-toluidine, 2,3-xylidine, 2,4-xylidine, 2,5-xylidine, 2,6-xylidine, 3,4-xylidine, 3,5-xylidine, o-chloroaniline, m-chloroaniline, p-chloroaniline, o-nitroaniline, o-bromoaniline, m-bromoaniline, o-nitroaniline, m-nitroaniline, p-nitroaniline, o-aminophenol, m-aminophenol, p-aminophenol, o-anilidine, m-anilidine, p-anilidine, o-phenetidine, m-phenetidine, p-phenetidine, o-aminobenzaldehyde, m-aminobenzaldehyde, p-aminobenzaldehyde, o-aminobenzonitrile, m-aminobenzonitrile, p-aminobenzonitrile, 2-aminobiphenyl, 3-aminobiphenyl, 4-aminobiphenyl, 2-aminophenol phenyl ether, 3-aminophenol phenyl ether, 4-aminophenol phenyl ether, 2-aminobenzophenone, 3-aminobenzophenone, 4-aminobenzophenone, 2-aminophenol phenyl sulfide, 3-aminophenol phenyl sulfide, 4-aminophenol phenyl sulfide, 2-aminophenol phenyl sulfone, 3-aminophenol phenyl sulfone, 4-aminophenol phenyl sulfone, α-naphthylamine, β-naphthylamine, 1-amino-2-naphthol, 2-amino-1-naphthol, 4-amino-1-naphthol, 5-amino-1-naphthol, 5-amino-1-naphthol, 5-amino-2-naphthol, 7-amino-2-naphthol, 8-amino-2-naphthol, 1-aminoanthracene, 2-aminoanthracene, 9-aminoanthracene and the like can be mentioned.

These monoamines may be used alone or in a combination of two or more kinds thereof. The amount of monoamine to be added is generally within the range of 0.001 - 0.5 mol relative to the total amount 100 mol of the aforementioned particular diamine and tetracarboxylic acid dianhydride, which are the main starting materials. Preferably, it is within the range of 0.005 - 0.25 mol.

Besides this, for formation of an adhesive layer, a polyamideimide resin, a polyether imide resin, a polyester imide resin and the like can be used alone or in an appropriate combination as long as the advantage of the present invention is not impaired.

As long as the advantage of the present invention is not impaired, a thermosetting adhesive, for example, an epoxy or cyanate adhesive, may be mixed with the thermoplastic adhesive of the present invention, and the proportion of the thermosetting adhesive is 40 mass % at most relative to the total mass of the adhesive composition constituting the adhesive layer.

The aforementioned thermoplastic polyimide resin can be produced by reacting the aforementioned respective components, and further, when the case demands, other tetracarboxylic acid dianhydride and other diamine, in an organic solvent, at a temperature not more than about 100˚C, particularly 20˚C - 60˚C, to give a polyamic acid solution, and using this polyamic acid solution as a dope solution.

In addition, a solution of a thermocompression bonding polyimide resin in an organic solvent can be obtained by affording a powder by heating a solution of polyamic acid produced as mentioned above to 150 - 250˚C, or adding an imidating agent to allow reaction at a temperature of 150˚C or below, particularly 15 - 50˚C, to perform imide cyclization and evaporating the solvent, or precipitation in a poor solvent, and dissolving the powder in an organic solution.

To obtain a thermoplastic polyimide resin in the present invention, respective components are preferably reacted in the aforementioned organic solvent in proportions such that the ratio of the amount of diamine used (the number of moles of amino group) to the total number of moles of acid anhydride (total mol of acid anhydride group of tetraacid dianhydride and dicarboxylic acid anhydride) is preferably 0.92 - 1.1, particularly 0.98 - 1.1, especially 0.99 - 1.1, and the ratio of the amount of dicarboxylic acid anhydride used to the number of moles of acid anhydride group of tetracarboxylic acid dianhydride is preferably not more than 0.05, particularly not more than 0.02.

When the proportion of the aforementioned diamine and dicarboxylic acid anhydride used is outside the aforementioned range, the obtained polyamic acid and thermoplastic polyimide obtained by imidating same have small molecular weights, which in turn decreases the adhesion strength of the flexible metal foil laminate. For the purpose of suppressing gelling of polyamic acid, a phosphorus stabilizer, for example, triphenyl phosphite, triphenyl phosphate and the like can be added within the range of 0.01 - 1 mass % relative to the solid (polymer) concentration during polymerization of polyamic acid. For the purpose of promoting imidation, a basic organic compound catalyst can be added to a dope solution.

For example, imidazole, 2-imidazole, 1,2-dimethylimidazole, 2-phenylimidazole and the like can be used in a proportion of 0.05 - 10 mass %, particularly 0.1 - 2 mass %, relative to polyamic acid. They are used to avoid insufficient imidation because a polyimide film is formed at a comparatively low temperature. For the purpose of stabilizing the adhesion strength, an organic aluminum compound, an inorganic aluminum compound or an organotin compound may be added to a thermocompression bonding polyimide starting material dope. For example, aluminum hydroxide, aluminum triacetylacetonate and the like can be added in a proportion of not less than 1 ppm, particularly 1 - 1000 ppm, as an aluminum metal relative to polyamic acid.

The organic solvent to be used for the aforementioned polyamic acid production are N-methyl-2-pyrrolidone, N,N-dimethylformamide, N,N-dimethylacetamide, N,N-diethylacetamide, dimethyl sulfoxide, hexamethylphosphoramide, N-methylcaprolactam, cresols and the like for any of the highly heat resistant polyimide and thermocompression bonding polyimide. These organic solvents may be used alone or in a combination of two or more kinds thereof.

Subjecting the polyimide film surface to a plasma treatment, a corona treatment, an alkali treatment prior to application of an adhesive is preferable for increasing the adhesive power, wherein the plasma is an inert gas plasma, and the inert gas includes nitrogen gas, Ne, Ar, Kr or Xe. The method of generating plasma is not particularly limited, and an inert gas is introduced into a plasma generator to allow production of plasma.

The time necessary for the plasma treatment is not particularly limited, but is generally 1 sec - 30 min, preferably 10 sec - 10 min. The frequency and the output of plasma during plasma treatment, and the gas pressure and the treatment temperature for plasma generation are particularly limited as long as they are within the range handlable by a plasma treatment apparatus. The frequency is generally 13.56 MHz, the output is generally 50 W - 1000 W, the gas pressure is generally 0.01 Pa - 10 Pa, and the temperature is generally 20˚C - 250˚C, preferably 20˚C - 180˚C. When the output is too high, the surface of the substrate film may be cracked. When the gas pressure is too high, the smoothness of the surface of substrate film may be degraded.

Then, an adhesive layer is formed on the surface-treated polyimide film surface. The method therefor is not limited and examples thereof include a method comprising applying and drying an adhesive on the polyimide film surface to form an adhesive layer, a method comprising forming an adhesive layer in advance on a releasable sheet or film, adhering or transferring this to a polyimide film surface and the like to form an adhesive layer on the polyimide film surface and the like.

The thus-obtained adhesive sheet can be utilized for a metal-laminated sheet wherein a metal foil is laminated on an adhesive layer of the aforementioned adhesive sheet, such as a die bonding tape and a lead on chip film.

The metal foil layer is laminated by superimposing a metal foil on an adhesive layer formed on the surface of a polyimide film with or without a plasma treatment, and applying a pressure, heat and the like.

As the metal for the metal foil, silver, copper, gold, platinum, rhodium, nickel, aluminum, iron, chrome, zinc, tin, brass, white copper, bronze, monel, tin-lead solder, tin-copper solder, tin-silver solder and the like may be used alone or as an alloy thereof. Use of copper is a preferable embodiment for balancing property and economic aspect. When the metal foil layer is used for a circuit (conductive), the metal foil layer has a thickness of preferably 1 - 175 $\mu$m, more preferably 3 - 50 $\mu$m. When a polyimide film laminated with a metal foil layer is used as a heat radiation substrate, the metal foil layer has a thickness of preferably 50 - 3000 $\mu$m.

While the surface roughness of the polyimide film laminated with this metal foil layer via an adhesive layer is not particularly limited, the central line average roughness (hereinafter to be indicated as Ra) and the ten-point average roughness (hereinafter to be indicated as Rz) according to JIS B 0601 (definition and indication of surface roughness) are preferably not more than 0.1 $\mu$m for Ra and not more than 1.0 $\mu$m for Rz.

In a preferable embodiment of the present invention, a metal-laminated sheet which is a complex of a polyimide film obtained by the above-mentioned method and a metal foil is further heat treated at 200 - 350˚C. This heat treatment is preferably performed at 220 - 330˚C, more preferably 240 - 310˚C. Due to the heat treatment, distortion possessed by a substrate film and distortion generated during production process of a metal-laminated sheet can be reduced, and the effect of the invention can be expressed still more effectively, and the durability and reliability of the aforementioned semiconductor package and the like can be improved. A temperature of less than 200˚C shows a small effect of reducing the distortion, and a temperature exceeding 350˚C is not preferable because the polyimide film substrate is deteriorated.

The thus-obtained metal-laminated sheet of the present invention can be used as a printed circuit board by removing unnecessary metal foil by etching to form a circuit pattern, and further, plural printed circuit boards may be laminated to give a multi-layer printed circuit board. For example, by a conventional method, a photoresist is applied to a conductive metal foil layer or a metal thick film layer later formed thereon as necessary and, after drying, subjected to the steps of exposure, development, etching and photoresist release to form a wiring circuit pattern, and further to application of solder resist, curing and electroless tin plating as necessary, whereby a flexible printed circuit board is obtained, which is then multi-layered to give a multi-layer printed circuit board. In addition, a printed circuit board and a semiconductor package, wherein a semiconductor chip is directly mounted on the printed circuit board, is obtained. The methods for the production of circuit and multi-layers, and mounting of semiconductor chip are not particularly limited and can be appropriately selected from conventionally-known methods and applied. As used herein, a metal thick film layer refers to a metal layer formed by electrolytic plating method, thick electroless plating method, calcination thick film method and the like. In particular, it refers to a metal layer formed by electrolytic plating method used for both surface through hole processing, via hole processing, via filling processing and the like.

For preparation of what is called a TAB tape having a flying lead, an adhesive sheet coated with an adhesive in advance is prepunched to ensure a device hole, after which a copper foil is laminated thereon, and a conductor pattern containing a flying lead can be formed according to a conventional method.

It is also possible to form a coated film of an inorganic material such as simple metal, metal oxide and the like on the surface of the metal (foil) layer or metal thick film layer later formed thereon as necessary. In addition, the surface of the metal foil layer or metal thick film layer later formed thereon as necessary may be subjected to a treatment with a coupling agent (aminosilane, epoxysilane and the like), a sandblast treatment, a holing treatment, a corona treatment, a plasma treatment, an etching treatment and the like.

An adhesive sheet, a metal-laminated sheet and a printed circuit board using a polyimide film having particular property of the present invention as a substrate are superior in the planarity and when processed, for example, into a printed circuit board and the like, it is free of warpage and distortion, showing superior flat plane retention as well as superior adhesion of a metal foil layer due to the maintained planarity.

Since uniform laminate processing is possible even when multiple layers are formed and the film shows small warpage and deformation, it is useful as a substrate for display driver, high-speed arithmetic device, graphic controller, high capacity memory element and the like requiring particularly highly dense, ultrafine wiring and often exposed to high temperature.

[Examples]

The present invention is explained in more detail in the following by referring to the Examples and Comparative Examples below, which are not to be construed as limitative. The evaluation method of the properties in the following Examples are as shown below, wherein the degree of curl after a heat treatment at 300˚C is based on the aforementioned method.

1. Thickness of polyimide film

A micrometer (Millitron (registered trade mark) 1245D manufactured by FEINPRUF) was used for the measurement.

2. Degree of warpage of polyimide film and sheet (apparent degree of warpage)

As shown in Fig. 1(C), a 50 mmx50 mm film test piece was stood still on a flat plane to form a concave, an average distance from each top point on the test piece to the flat plane (h1, h2, h3, h4: unit mm) was taken as the amount of warpage (mm), and a value shown by the percentage (%) of the amount of warpage relative to the distance (35.36 mm) from each top point on the test piece to the center was obtained.

Specifically, it was calculated by the following formulas.

$$\text{amount of warpage (mm)} = (h1+h2+h3+h4)/4$$

$$\text{degree of warpage (\%)} = 100 \times (\text{amount of warpage})/35.36$$

The samples were taken from two points in the width direction and the length direction of the polyimide film or the sheet (basically from points at 1/3 and 2/3 of the beam length, when not possible, taken from the points as near as possible to the central portion), total 4 points, and an average value thereof was used.

The abbreviations of the compounds used in the Examples and the like are shown below.

PMDA: pyromellitic acid dianhydride
TMHQ: P-phenylenebis(trimellitic acid monoester acid anhydride)
ODA: 4,4'-diaminodiphenyl ether
P-PDA: para-phenylenediamine
BPDA: 3,3',4,4'-biphenyltetracarboxylic acid dianhydride
DMF: dimethylformamide
DMAC: dimethylacetamide
AA: acetic anhydride
IQ: isoquinoline

In addition, the abbreviation GF shows a polyimide precursor film (green film) and the abbreviation IF shows a polyimide film.

(Production Examples 1 - 3)

A container equipped with a nitrogen inlet tube, a thermometer and a stirrer bar was substituted with nitrogen, and ODA was placed therein. Then, DMAC was added and, after complete dissolution, PMDA was added, and the mixture was polymerized by stirring at 25°C for 5 hr at a molar ratio of ODA and PMDA as monomers of 1/1 in DMAC while adjusting the monomer charge concentration to 15 mass %. As a result, a brown viscous polyamic acid solution was obtained.

AA (15 parts by mass) and IQ (3 parts by mass) were added to the obtained polyamic acid solution (100 parts by mass), and the mixture was applied to the lubricant-free surface of a polyester film (COSMOSHINE (registered trade mark) A4100, manufactured by Toyo Boseki Kabushiki Kaisha) having a thickness of 188 micron and a width of 800 mm, in a coating width of 740 mm (squeegee/belt gap 430 $\mu$m). The film was dried during passage through a continuous drying furnace having 4 drying zones. In each zone, 3 rows of slit-like air outlets were set for each of the above and under the film, hot air temperature between respective air outlets was controllably set to $\pm 1.5$°C, and the air amount difference was controllably set to $\pm 3$%. In the width direction, the temperature was controlled to $\pm 1$°C for the width corresponding to 1.2-fold of the film effective width.

The drying furnace was set as follows. In the drying conditions, the temperature is at 30 mm above and under the film.

leveling zone temperature 25°C, no air amount

first zone upper side temperature 105°C, lower side temperature 105°C
air amount, both upper and lower 20 - 25 m$^3$/min
second zone upper side temperature 100°C, lower side temperature 100°C

air amount, both upper and lower 30 - 35 $m^3$/min

third zone upper side temperature 95°C, lower side temperature 100°C

air amount, both upper and lower 20 - 25 $m^3$/min

fourth zone upper side temperature 90°C, lower side temperature 100°C

upper side air amount 15 - 18 $m^3$/min, lower side air amount 20 - 25 $m^3$/min

The length of each zone was the same and the total drying time was 18 min.

The air amount was the total of the air amount from the air outlet of each zone. In the Production Example 1, Production Example 2 and Production Example 3, the amount was changed within the above-mentioned range.

Under such drying conditions, the coated film surface up to the third zone did not reach the dry state by touch, which confirmed the almost constant rate of drying conditions.

The coated film surface reached the dry to touch state shortly after entering the fourth zone and the drying proceeded in a rate decreasing drying manner thereafter. At this point, the temperature and the air amount on the lower side were set higher than those of the upper side to promote diffusion of the solvent in the coated film.

By a thermocouple supported at 10 mm above the film and in a part directly beneath the air outlet at the center of each zone, it was confirmed by 10 cm interval monitoring that the temperature was ±1.5°C.

By releasing the polyamic acid film (GF) that became self-supporting after the drying from the polyester film, each GF, i.e., Production Example 1, Production Example 2 and Production Example 3 were obtained. The value of $|IM_A-IM_B|$ for this each GF was 0.8, 1.2 and 3.9, respectively.

Each of the obtained GFs was subjected to 2-step heating under the conditions of first step: 180°C, 5 min, temperature rise rate 4°C/sec, second step: 400°C, 5 min, by passing the films through a nitrogen-substituted continuous heat treating furnace while holding the both ends thereof on a pin tenter to perform an imidation reaction. Thereafter, by cooling to room temperature over 5 min, each brown IF (polyimide film), IF Production Example 1, IF Production Example 2 and IF Production Example 3 were obtained.

During the heat treatment of the GFs, brushes made of aromatic polyamide monofilament strands were set in contact with the both ends of the film, so that the both ends of the film could be uniformly pierced by the pins of the pin tenter.

The thickness and degree of curl of each IF obtained were 15 μm, 2.8% for IF Production Example 1, 15.1 μm, 4.1% for IF Production Example 2, and 15 μm, 7.5% for IF Production Example 3.

(Production Examples 4 - 6)

Using PMDA and BPDA as an aromatic tetracarboxylic acid dianhydride component and ODA and P-PDA as a diamine component, the four kinds of monomers were polymerized at a molar ratio of PMDA/BPDA/ODA/P-PDA of 1/0.5/1/0.5 in DMF while adjusting the monomer charge concentration to 16 mass % to give a solution of polyamic acid in DMF. The obtained polyamic acid solution was applied to a stainless belt (gap between squeegee/belt 400 μm), and dried in the same manner as in Production Examples 1 - 3. By releasing the polyamic acid film that became self-supporting after the drying from a stainless belt, each green film having a thickness of 49.5 μm, i.e., Production Examples 4 - 6 were obtained. The value of $|IM_A-IM_B|$ for respective GFs was 1.4, 4.2 and 4.8, respectively.

The obtained GFs were subjected to 2-step heating under the conditions of first step: 180°C, 3 min, temperature rise rate 4°C/sec, second step: 460°C, 2 min, by passing the films through a nitrogen-substituted continuous heat treating furnace to perform an imidation reaction. Thereafter, by cooling to room temperature over 5 min, each brown IF (polyimide film) having a thickness of 25 μm, IF Production Example 4, IF Production Example 5 and IF Production Example 6 were obtained.

During the heat treatment of the GFs, brushes made of aromatic polyamide monofilament strands were set in contact with the both ends of the film, so that the both ends of the film could be uniformly pierced by the pins of the pin tenter.

The thickness and degree of curl of each IF obtained were 15 μm, 4.8% for IF Production Example 4, 15.1 μm, 7.8% for IF Production Example 5 and 15 μm, 9.5% for IF Production Example 6.

(Production Examples 7 - 9)

AA (15 parts by mass) and IQ (3 parts by mass) were added to the polyamic acid solution obtained in Production Example 1 (100 parts by mass), and the mixture was applied to a stainless belt (squeegee/belt gap 430 μm) and dried in a dryer similar to that in Production Examples 1 - 3. The drying conditions (temperature at 30 mm above and under the film) were as follows.

leveling zone temperature 25°C, no air amount

first zone temperature 110°C for above and under

air amount, both upper and lower 20 - 25 $m^3$/min second zone temperature 120°C for above and under

air amount, both upper and lower 20 - 25 $m^3$/min third zone temperature 120°C for above and under

air amount, both upper and lower 20 - 25 $m^3$/min

fourth zone temperature 120˚C for above and under

air amount, both upper and lower 20 - 25 m$^3$/min

The length of each zone was the same and the total drying time was 9 min.

The air amount was the total of the air amount from the air outlet of each zone. In the Production Example 7, Production Example 8 and Production Example 9, the amount was changed within the above-mentioned range.

Under such drying conditions, the coated film surface reached the dry state by touch at the center of the second zone, and it is presumed that the drying proceeded in a rate decreasing drying manner thereafter.

By releasing the polyamic acid film that became self-supporting after the drying from the stainless belt, respective three kinds of GF, i.e., Production Example 7, Production Example 8 and Production Example 9 were obtained. The value of |IM$_A$-IM$_B$| for respective GFs was 5.2, 8.1 and 12.7, respectively.

Each of the obtained GFs was subjected to 2-step heating under the conditions of first step: 180˚C, 5 min, temperature rise rate 4˚C/sec, second step: 400˚C, 5 min, by passing the films through a nitrogen-substituted continuous heat treating furnace while holding the both ends thereof on a pin tenter to perform an imidation reaction. Thereafter, by cooling to room temperature over 5 min, each brown IF (polyimide film), IF Production Example 7, IF Production Example 8 and IF Production Example 9 were obtained.

The thickness and degree of curl of each IF obtained were 15 $\mu$m, 10.8% for IF Production Example 7, 15.1 $\mu$m, 14.1% for IF Production Example 8 and 15 $\mu$m, 22.5% for IF Production Example 9.

(Production Examples 10 - 12)

A container equipped with a nitrogen inlet tube, a thermometer and a stirrer bar was substituted with nitrogen, and P-PDA was placed therein. Then, DMAC was added and, after complete dissolution, BPDA was added, and the mixture was polymerized by stirring at 25˚C for 5 hr at a molar ratio of P-PDA and BPDA as monomers of 1/1 in DMAC while adjusting the monomer charge concentration to 15 mass %. As a result, a brown viscous polyamic acid solution was obtained. AA (15 parts by mass) and IQ (3 parts by mass) were added to the obtained polyamic acid solution (100 parts by mass), and the mixture was applied to the lubricant-free surface of a polyester film (COSMOSHINE (registered trade mark) A4100, manufactured by Toyo Boseki Kabushiki Kaisha) having a thickness of 188 micron and a width of 800 mm, in a coating width of 740 mm (squeegee/belt gap 430 $\mu$m). The film was dried during passage through a continuous drying furnace having 4 drying zones. In each zone, 3 rows of slit-like air outlets were set for each of the above and under the film, hot air temperature between respective air outlets was controllably set to $\pm$1.5˚C, and the air amount difference was controllably set to $\pm$3%. In the width direction, the temperature was controlled to $\pm$1˚C for the width corresponding to 1.2-fold of the film effective width.

The temperature at 30 mm above and under the film was set as follows.

Drying conditions A

leveling zone temperature 25˚C, no air amount

first zone upper side temperature 105˚C, lower side temperature 105˚C

air amount, both upper and lower 20 - 25 m$^3$/min

second zone upper side temperature 100˚C, lower side temperature 100˚C

air amount, both upper and lower 30 - 35 m$^3$/min

third zone upper side temperature 95˚C, lower side temperature 100˚C

air amount, both upper and lower 20 - 25 m$^3$/min

fourth zone upper side temperature 90˚C, lower side temperature 100˚C

upper side air amount 15 m$^3$/min, lower side air amount 20 m$^3$/min

The length of each zone was the same and the total drying time was 18 min.

The air amount was the total of the air amount from the air outlet of each zone. In the Production Example 10, Production Example 11 and Production Example 12, the amount was changed within the above-mentioned range.

Under such drying conditions, the coated film surface up to the third zone did not reach the dry state by touch, which confirmed the almost constant rate of drying conditions.

The coated film surface reached the dry to touch state shortly after entering the fourth zone and the drying proceeded in a rate decreasing drying manner thereafter. At this point, the temperature and the air amount on the lower side were set higher than those of the upper side to promote diffusion of the solvent in the coated film.

By a thermocouple supported at 10 mm above the film and in a part directly beneath the air outlet at the center of each zone, it was confirmed by 10 cm interval monitoring that the temperature was $\pm 1.5°C$.

By releasing the GF (polyamic acid film) that became self-supporting after the drying from the polyester film, each GF (green film), i.e., Production Example 10, Production Example 11 and Production Example 12 were obtained. The value of $|IM_A-IM_B|$ for respective GFs was 0.8, 1.2 and 3.9, respectively. The release ambient temperature was 27°C. In the following Production Examples, the films were peeled off under similar conditions.

Each of the obtained GFs (green films) was subjected to 2-step heating under the conditions of first step: 180°C, 5 min, temperature rise rate 4°C/sec, second step: 400°C, 5 min, by passing the film through a nitrogen-substituted continuous heat treating furnace while holding the both ends thereof on a pin tenter to perform an imidation reaction. Thereafter, by cooling to room temperature over 5 min, each brown polyimide film, i.e., IF Production Example 10, IF Production Example 11 and IF Production Example 12 were obtained.

During the heat treatment of the green films, brushes made of aromatic polyamide monofilament strands were set in contact with the both ends of the film, so that the both ends of the film could be uniformly pierced by the pins of the pin tenter.

The thickness and degree of curl of each IF obtained were 15 $\mu$m, 2.6% for IF Production Example 10, 15.1 $\mu$m, 3.9% for IF Production Example 11 and 15 $\mu$m and 7.3% for IF Production Example 12.

(Production Examples 13 - 15)

A container equipped with a nitrogen inlet tube, a thermometer and a stirrer bar was substituted with nitrogen, and P-PDA was placed therein. Then, DMAC was added and, after complete dissolution, BPDA was added, and the mixture was polymerized by stirring at 25°C for 5 hr at a molar ratio of P-PDA and BPDA as monomers of 1/1 in DMAC while adjusting the monomer charge concentration to 15 mass %. As a result, a brown viscous polyamic acid solution was obtained. The obtained polyamic acid solution was applied to a stainless belt (gap between squeegee/belt 450 $\mu$m), and dried in the same manner as in Production Examples 10 - 12.

By releasing the GF (polyamic acid film) that became self-supporting after the drying from the polyester film, each GF, Production Example 13, Production Example 14 and Production Example 15 were obtained. The value of $|IM_A-IM_B|$ for respective GFs was 1.1, 1.5 and 4.2, respectively.

The obtained GFs were subjected to 2-step heating under the conditions of first step: 180°C, 3 min, temperature rise rate 4°C/sec, second step: 460°C, 2 min, by passing the films through a nitrogen-substituted continuous heat treating furnace to perform an imidation reaction. Thereafter, by cooling to room temperature over 5 min, each brown IF, i.e., IF Production Example 13, IF Production Example 14 and IF Production Example 15 were obtained.

During the heat treatment of the GFs, brushes made of aromatic polyamide monofilament strands were set in contact with the both ends of the film, so that the both ends of the film could be uniformly pierced by the pins of the pin tenter.

The thickness and degree of curl of each IF obtained were 15 $\mu$m, 4.3% for IF Production Example 13, 15.1 $\mu$m, 5.5% for IF Production Example 14 and 15 $\mu$m, 8.3% for IF Production Example 15.

(Production Examples 16 - 18)

AA (15 parts by mass) and IQ (3 parts by mass) were added to the polyamic acid solution obtained in Production Example 10 (100 parts by mass), and the mixture was applied to a stainless belt (squeegee/belt gap 430 $\mu$m) and dried in a dryer similar to that in Production Examples 10 - 12. The drying conditions (temperature at 30 mm above and under the film) were as follows.

leveling zone temperature 25°C, no air amount
first zone temperature 110°C for above and under

air amount, both upper and lower 20 - 25 m$^3$/min second zone temperature 120°C for above and under
air amount, both upper and lower 20 - 25 m$^3$/min third zone temperature 120°C for above and under
air amount, both upper and lower 20 - 25 m$^3$/min fourth zone temperature 120°C for above and under
air amount, both upper and lower 20 - 25 m$^3$/min

The length of each zone was the same and the total drying time was 9 min.

The air amount was the total of the air amount from the air outlet of each zone. In the Production Example 16, Production Example 17 and Production Example 18, the amount was changed within the above-mentioned range.

Under such drying conditions, the coated film surface reached the dry state by touch at the center of the second zone, and it is presumed that the drying proceeded in a rate decreasing drying manner thereafter.

By releasing the GF that became self-supporting after the drying from the stainless belt, 3 kinds of GF, i.e., Production Example 16, Production Example 17 and Production Example 18 were obtained.

The value of $|IM_A-IM_B|$ for respective GFs was 5.3, 7.5 and 11.2, respectively.

Each of the obtained GFs was subjected to 2-step heating under the conditions of first step: 180˚C, 5 min, temperature rise rate 4˚C/sec, second step: 400˚C, 5 min, by passing the films through a nitrogen-substituted continuous heat treating furnace while holding the both ends thereof on a pin tenter to perform an imidation reaction. Thereafter, by cooling to room temperature over 5 min, each brown IF, IF Production Example 16, IF Production Example 17 and IF Production Example 18 were obtained.

The thickness and degree of curl of each IF obtained were 15 $\mu$m, 10.5% for IF Production Example 16, 15.1 $\mu$m, 14.1% for IF Production Example 17, and 15 $\mu$m, 18.5% for IF Production Example 18.

(Examples 1 - 6, Comparative Examples 1 - 3)

<Production of adhesive sheet>

Using respective polyimide films obtained in Production Examples 1 - 9, adhesive sheets were obtained in the following manner.

Using N,N-dimethylacetamide as an organic polar solvent, 1,3-bis(3-aminophenoxy)benzene and 3,3'-dihydroxy-4,4'-diaminobiphenyl at a molar ratio 9:1 as a diamine compound, and 3,3',4,4'-ethyleneglycol benzoate tetracarboxylic acid dianhydride as ester tetracarboxylic acid, a solution of a polyamic acid polymer was obtained. The polyamic acid polymer solution was heated under reduced pressure to give a thermoplastic polyimide.

The thermoplastic polyimide (80 parts by mass), Epikote 1032H60 (100 parts by mass) as a thermosetting resin (epoxy resin), and 4,4'-diaminodiphenyl ether (30 parts by mass) as a curing agent were added to dioxolane (910 parts by mass) as an organic solvent, and the mixture was dissolved by stirring. In this way, an adhesive solution was obtained.

The obtained adhesive solution was cast on one surface of a 12.5 $\mu$m thick releasable polyethylene terephthalate film having a release layer formed on one surface thereof, and dried at 60˚C for 2 min to give 2.5 $\mu$m-thick adhesive layer-formed polyethylene terephthalate film.

The adhesive layer of the thus-obtained adhesive layer-formed polyethylene terephthalate film and one surface of the polyimide film obtained in the aforementioned Production Example were superimposed and laminated to give a one surface adhesive sheet from each polyimide film (respective polyimide films having the same end number and obtained in the above-mentioned Production Examples were used in KTS Examples 1 - 6, and the respective films obtained in IF Production Examples 7 - 9 were used in KTS Comparative Examples 1 - 3, hereinafter the same). The total thickness of the polyimide film and adhesive layer in the obtained adhesive sheet was 17.5 $\mu$m.

The adhesive layers of two thus-obtained films were superimposed and laminated on both surfaces of the polyimide film obtained in the aforementioned Production Examples to give respective adhesive sheets from respective polyimide films (RYS Examples 1 - 6 and RYS Comparative Examples 1 - 3). The total thickness of the polyimide film and adhesive layer in the obtained adhesive sheet was 20 $\mu$m.

The obtained each adhesive sheet was evaluated by an average of the degrees of warpage. Each sheet having an average degree of warpage exceeding 10% was rated ×, a sheet having a degree of warpage exceeding 7% and up to 10% was rated Δ, a sheet showing 3 - 7% was rated ○, and a sheet showing less than 3% was rated ⊙.

As a result, all of KTS Example 1, KTS Example 2 and KTS Example 4 were ⊙, KTS Example 3 and KTS Example 5 were ○, KTS Example 6 was Δ, and all of KTS Comparative Example 1, KTS Comparative Example 2 and KTS Comparative Example 3 were ×.

All of RYS Example 1, RYS Example 2, RYS Example 3, RYS Example 4 and RYS Example 5 were ⊙, RYS Example 6 was ○, RYS Comparative Example 1 was Δ, and RYS Comparative Example 2 and RYS Comparative Example 3 were ×.

<Production of metal-laminated sheet>

Respective polyimide films obtained in Production Examples 1 - 9 were used. Each polyimide film was slit to a width of 508 mm and subjected to a corona treatment. Then, RV50 (trade name) manufactured by TOYO BOSEKI KABUSHIKI KAISHA was applied as an adhesive to the surface of each polyimide film to a thickness of 18 $\mu$m, dried in a dry oven at 80˚C for 15 min, and each adhesive sheet was obtained from each polyimide film. The adhesion treated surface of the electrolytic copper foil (18 $\mu$m) and the adhesive-coated surface of the aforementioned adhesive sheet were matched, laminated with a silicone rubber roller type laminator at a roll temperature of 120°C, feeding rate 60 cm/min, wound and treated in a vacuum dryer at 150°C for 5 hr to cure the adhesive, whereby each metal-laminated sheet was obtained from each polyimide film (KTM Examples 1 - 6 and KTM Comparative Examples 1 - 3).

The obtained each metal-laminated sheet was evaluated by an average of the degrees of warpage. A metal-laminated sheet having an average degree of warpage exceeding 10% was rated ×, a sheet having a degree of warpage exceeding 7% and up to 10% was rated Δ, a sheet showing 3 - 7% was rated ○, and a sheet showing less than 3% was rated ⊙.

As a result, all of KTM Example 1, KTM Example 2, KTS Example 3, KTM Example 4 and KTM Example 5 were ⊙, KTM Example 6 was ○, KTM Comparative Example 1 was Δ, and KTM Comparative Example 2 and KTM Comparative Example 3 were ×.

<Production of printed circuit board>

Each metal-laminated sheet obtained in the above (copper-plated laminate film) was slit in a 105 mm width, sprocket holes for transport and holes for alignment were punched out on both ends, and set on a continuous processing machine for COF processing. Then, according to a general single-sided circuit processing process, a photoresist was applied on the surface of a rolled copper foil, exposed to a given pattern and developed. Using a patterned resist as a mask, an etching treatment was applied using an aqueous ferric chloride solution. A liquid resist type solder resist was applied and dried except a pad, which was followed by mask exposure and development. The pad was plated with tin in a thickness of 1.5 $\mu$m to give a printed circuit board (film substrate for COF) from each polyimide film. The circuit having the smallest wire width on the obtained each film substrate for COF showed wire width/wire interval=50/50 $\mu$m.

A semiconductor chip was mounted on the obtained film substrate for COF, a bonding treatment was applied using flip chip bonding, and resin sealing was performed by a potting method to give 2000 pieces each of semiconductor packages (SCJ Example 1 - SCJ Example 6, SCJ Comparative Example 1 - SCJ Comparative Example 3). The number of contact points between chip/substrate of the obtained respective semiconductor packages was 256. The packages were set on an ETAC (R) temperature cycle test apparatus (manufactured by Kusumoto Chemicals, Ltd.) and a heating cooling test was performed. The test included heating and cooling by repeating temperature rise and fall between a low temperature of -50°C and a high temperature of 150°C every 30 min. The test time was set to 3000 hr. After the test, a continuity test was performed, and a fraction defective of the connection points was determined.

For evaluation of connection points, a fraction defective of less than 10 ppm was rated ⊙, 10 - 30 ppm was rated ○, and more than 30 ppm was rated ×.

As the evaluation results, all of SCJ Example 1, SCJ Example 2, SCJ Example 3, SCJ Example 4 and SCJ Example 5 were ⊙, SCJ Example 6 was ○, and all of SCJ Comparative Example 1, SCJ Comparative Example 2 and SCJ Comparative Example 3 were ×.

(Examples 7 - 12, Comparative Examples 4 - 6)

<Production of metal-laminated sheet>

Respective polyimide films obtained in Production Examples 1 - 9 were used. Each polyimide film was slit to a width of 508 mm and subjected to a corona treatment. Then, RV50 (trade name) manufactured by TOYO BOSEKI KABUSHIKI KAISHA was applied as an adhesive to the both surfaces of each polyimide film to a coating thickness of 18 $\mu$m, dried in a dry oven at 80°C for 15 min, and each adhesive sheet was obtained from each polyimide film. The adhesion treated surface of the electrolytic copper foil (12 $\mu$m) and the adhesive-coated surface of the aforementioned adhesive sheet were matched, laminated with a silicone rubber roller type laminator at a roll temperature of 120°C, feeding rate 60 cm/min, wound and treated in a vacuum dryer at 150°C for 5 hr to cure the adhesive, whereby each double-sided metal-laminated sheet was obtained from each polyimide film (RYM Examples 7 - 12 and RYM Comparative Examples 4 - 6).

The obtained each metal-laminated sheet was evaluated by an average of the degree of warpage. A metal-laminated sheet having an average degree of warpage exceeding 10% was rated ×, a sheet having a degree of warpage exceeding 7% and up to 10% was rated Δ, a sheet showing 3 - 7% was rated ○, and a sheet showing less than 3% was rated ⊙.

As a result, all of RYM Example 7, RYM Example 8, RYS Example 9, RYM Example 10 and RYM Example 11 were ⊙, RYM Example 12 was ○, RYM Comparative Example 4 was Δ, and RYM Comparative Example 5 and RYM Comparative Example 6 were ×.

<Production of printed circuit board>

A negative resist having a film thickness of 6 μm was formed using a liquid resist on one surface of each double-sided metal-laminated sheet prepared above, and a copper layer was removed by etching to form a 4.8 cmx4.8 cm test circuit pattern containing an ultrafine wire with wire interval/wire width of 18 μm/12 μm and assuming mounting on LCD driver. In the same manner as above, a 4 mm square pattern was formed on the backside in a lattice shape wherein the distance between patterns was 0.5 mm, and a number of test circuit substrates (TPR Examples 7 - 12 and TPR Comparative Examples 4 - 6) were prepared in the same manner from each polyimide film. The pattern area density was 50% for both the front and the back.

As shown in Fig. 2, three sheets of each test circuit substrate prepared were produced, each adhesive sheet of Examples 1 - 6, Comparative Examples 1 - 3 was set between respective test circuit substrates (RYS Examples 1 - 6 and RYS Comparative Examples 1 - 3), and each single-sided adhesive sheet of Examples 1 - 6, Comparative Examples 1 - 3 was set on the outermost layer of each test circuit substrate (KTS Examples 1 - 6 and KTS Comparative Examples 1 - 3) such that they are constituted with the same polyimide film, they were laminated by hot press at 150°C to give respective test multi-layer substrates. The obtained multi-layer substrates were immersed in a tin-silver solder bath at 260°C for 15 sec and the presence or absence of pattern abnormality was evaluated by observation.

In respective test multi-layer substrates from the polyimide films of IF Production Examples 1 - 6, no detachment of the pattern was observed. In respective test multi-layer substrates from the polyimide films of IF Production Examples 7 - 9, however, detachment of the pattern was observed.

In addition, for observation of the section, each test multi-layer substrate was cut in the direction allowing exposure of the section in the width direction of the ultrafine wire pattern, embedded in a resin, polished at the end surface and observed under a microscope in an enlarged view. It was evaluated whether the adhesive sheet between the test multi-layer substrates had a deformation as shown in Fig. 3.

In respective test multi-layer substrates using the polyimide films of IF Production Examples 1 - 6, no deformation of adhesive sheet was observed. In respective test multi-layer substrates using the polyimide films of IF Production Examples 7 - 9, however, deformation of adhesive sheet was observed.

(Examples 13 - 18, Comparative Examples 7 - 9)

<Production of adhesive sheet>

Using respective polyimide films obtained in Production Examples 10 - 18, adhesive sheets were obtained in the following manner.

Using N,N-dimethylacetamide as an organic polar solvent, 1,3-bis(3-aminophenoxy)benzene and 3,3'-dihydroxy-4,4'-diaminobiphenyl at a molar ratio 9:1 as a diamine compound, and 3,3',4,4'-ethyleneglycol benzoate tetracarboxylic acid dianhydride as ester tetracarboxylic acid, a solution of a polyamic acid polymer was obtained. The polyamic acid polymer solution was heated under reduced pressure to give a thermoplastic polyimide.

The thermoplastic polyimide (80 parts by mass), Epikote 1032H60 (100 parts by mass) as a thermosetting resin (epoxy resin), and 4,4'-diaminodiphenyl ether (30 parts by mass) as a curing agent were added to dioxolane (910 parts by mass) as an organic solvent, and the mixture was dissolved by stirring. In this way, an adhesive solution was obtained.

The obtained adhesive solution was cast on one surface of a 12.5 μm thick releasable polyethylene terephthalate film having a release layer formed on one surface thereof, and dried at 60°C for 2 min to give 2.5 μm-thick adhesive layer.

The adhesive layer of the obtained film and one surface of the polyimide film obtained in the aforementioned Production Example were superimposed and laminated to give each single-sided adhesive sheet from each polyimide film (KTS Examples 13 - 18 and KTS Comparative Examples 7 - 9; respective polyimide films obtained in the above-mentioned Production Examples 10 - 15 were used in KTS Examples 13 - 18, and respective polyamide films obtained in the above-mentioned Production Examples 16 - 18 were used in KTS Comparative Examples 7 - 9, hereinafter the same). The total thickness of the polyimide film and the adhesive layer in the obtained adhesive sheet was 17.5 μm.

The adhesive layers of two thus-obtained films were superimposed and laminated on both surfaces of the polyimide film obtained in the aforementioned Production Examples to give respective adhesive sheets from respective polyimide films (RYS Examples 13 - 18 and RYS Comparative Examples 7 - 9). The total thickness of the polyimide film and adhesive layer in the obtained adhesive sheet was 20 μm.

The obtained each adhesive sheet was evaluated by an average of the degree of warpage. Each sheet having an average degree of warpage exceeding 10% was rated ×, a sheet having a degree of warpage exceeding 7% and up to 10% was rated Δ, a sheet showing 3 - 7% was rated ○, and a sheet showing less than 3% was rated ⊙.

As a result, all of KTS Example 13, KTS Example 14, KTS Example 16 were ⊙, KTS Example 15 and KTS Example 17 were ○, KTS Example 18 was Δ, and all of KTS Comparative Example 7, KTS Comparative Example 8 and KTS Comparative Example 9 were ×.

All of RYS Example 13, RYS Example 14, RYS Example 15, RYS Example 16 and RYS Example 17 were ⊙, RYS Example 18 was ○, RYS Comparative Example 7 was Δ, and RYS Comparative Example 8 and RYS Comparative Example 9 were ×.

<Production of metal-laminated sheet>

Respective polyimide films obtained in Production Examples 10 - 18 were used. Each polyimide film was slit to a width of 508 mm and subjected to a corona treatment. Then, RV50 (trade name) manufactured by TOYO BOSEKI KABUSHIKI KAISHA was applied as an adhesive to the surface of each polyimide film to a thickness of 18 μm, dried in a dry oven at 80˚C for 15 min, and each adhesive sheet was obtained from each polyimide film. The adhesion treated surface of a rolled copper foil (BHY-22-T, trade name, 18 μm) manufactured by JAPAN ENERGY CORPORATION and the adhesive-coated surface of the aforementioned adhesive sheet were matched, laminated with a silicone rubber roller type laminator at a roll temperature of 120˚C, feeding rate 60 cm/min, wound and treated in a vacuum dryer at 150˚C for 5 hr to cure the adhesive, whereby each metal-laminated sheet was obtained from each polyimide film (KTM Examples 13 - 18 and KTM Comparative Examples 7 - 9).

The obtained each metal-laminated sheet was evaluated by an average of the degrees of warpage. A metal-laminated sheet having an average degree of warpage exceeding 10% was rated ×, a sheet having a degree of warpage exceeding 7% and up to 10% was rated Δ, a sheet showing 3 - 7% was rated ○, and a sheet showing less than 3% was rated ⊙.

As a result, all of KTM Example 13, KTM Example 14, KTS Example 15, KTM Example 16 and KTM Example 17 were ⊙, KTM Example 18 was ○, KTM Comparative Example 7 was Δ, and KTM Comparative Example 8 and KTM Comparative Example 9 were ×.

<Production of printed circuit board>

Each metal-laminated sheet obtained in the above (copper-plated laminate film) was slit in a 105 mm width, sprocket holes for transport and holes for alignment were punched out on both ends, and set on a continuous processing machine for COF processing. Then, according to a general single-sided circuit processing process, a photoresist was applied on the surface of a rolled copper foil, exposed to a given pattern and developed. Using a patterned resist as a mask, an etching treatment was applied using an aqueous ferric chloride solution. A liquid resist type solder resist was applied and dried except a pad, which was followed by mask exposure and development. The pad was plated with tin in a thickness of 1.5 μm to give a printed circuit board (film substrate for COF) from each polyimide film. The circuit having the smallest wire width on each obtained film substrate for COF showed wire width/wire interval=60/60 μm.

A semiconductor chip was mounted on the obtained film substrate for COF, a bonding treatment was applied using flip chip bonding, and resin sealing was performed by a potting method to give respective semiconductor packages (SCJ Example 13 - SCJ Example 18, SCJ Comparative Example 7 - SCJ Comparative Example 9). The number of contact points between chip/substrate of the obtained respective semiconductor packages was 256. The packages were set on an ETAC (R) temperature cycle test apparatus (manufactured by Kusumoto Chemicals, Ltd.) and a heating cooling test was performed. The test included heating and cooling by repeating between a low temperature of -50˚C and a high temperature of 150˚C every 30 min. The test time was set to 3000 hr. After the test, a continuity test was performed, and a fraction defective of the connection points was determined.

For evaluation of connection points, a fraction defective of less than 10 ppm was rated ⊙, 10 - 30 ppm was rated ○, and more than 30 ppm was rated ×.

As the evaluation results, all of SCJ Example 13, SCJ Example 14, SCJ Example 15, SCJ Example 16 and SCJ Example 17 were ⊙, SCJ Example 18 was ○, and all of SCJ Comparative Example 7, SCJ Comparative Example 8 and SCJ Comparative Example 9 were ×.

(Examples 19 - 24, Comparative Examples 10 - 12)

<Production of metal-laminated sheet>

Respective polyimide films obtained in Production Examples 10 - 18 were used. Each polyimide film was slit to a width of 508 mm and subjected to a corona treatment. Then, RV50 (trade name) manufactured by TOYO BOSEKI KABUSHIKI KAISHA was applied as an adhesive to the both surface of each polyimide film to a thickness of 18 μm, dried in a dry oven at 80˚C for 15 min, and each adhesive sheet was obtained from each polyimide film. The adhesion treated surface of the electrolytic copper foil (12 μm) and the adhesive-coated surface of the aforementioned adhesive sheet were matched, laminated with a silicone rubber roller type laminator at a roll temperature of 120˚C, feeding rate 60 cm/min, wound and treated in a vacuum dryer at 150˚C for 5 hr to cure the adhesive, whereby each double-sided metal-laminated sheet was obtained from each polyimide film (RYM Example 19 - RYM Example 24 and RYM Comparative Example 10 - RYM Comparative Example 12).

The obtained each metal-laminated sheet was evaluated by an average of the degree of warpage. A metal-laminated sheet having an average degree of warpage exceeding 10% was rated ×, a sheet having a degree of warpage exceeding 7% and up to 10% was rated ×, a sheet having a degree of warpage exceeding 7% and up to 10% was rated Δ, a sheet showing 3 - 7% was rated ○, and a sheet showing less than 3% was rated ⊙.

As a result, all of RYM Example 19, RYM Example 20, RYS Example 21, RYM Example 22 and RYM Example 23 were ⊙, RYM Example 24 was ○, RYM Comparative Example 10 was Δ, and RYM Comparative Example 11 and RYM Comparative Example 12 were ×.

<Production of printed circuit board>

A negative resist having a film thickness of 6 μm was formed using a liquid resist on one surface of each double-sided metal-laminated sheet prepared above, and a copper layer was removed by etching to form a 4.8 cmx4.8 cm test circuit pattern containing an ultrafine wire with wire interval/wire width of 17 μm/13 μm and assuming mounting on LCD driver. In the same manner as above, a 4 mm square pattern was formed on the backside in a lattice shape wherein the distance between patterns was 0.5 mm, and a number of test circuit substrates (TPR Example 19 - TPR Example 24 and TPR Comparative Example 10 - TPR Comparative Example 12) were prepared in the same manner from each polyimide film. The pattern area density was 50% for both the front and the back.

Three sheets of each test circuit substrate prepared were produced, each adhesive sheet of Examples 13 - 18, Comparative Examples 7 - 9 was set between respective test circuit substrates (RYS Example 13 - RYS Example 18 and RYS Comparative Example 7 - RYS Comparative Example 9), and each single-sided adhesive sheet of Examples 13 - 18, Comparative Examples 7 - 9 was set on the outermost layer of each test circuit substrate (KTS Example 13 - KTS Example 18 and KTS Comparative Example 10 - KTS Comparative Example 12) such that they are constituted with the same polyimide film, they were laminated by hot press at 150˚C to give respective test multi-layer substrates having multiple layers. The obtained multi-layer substrates were immersed in a tin-silver solder bath at 260˚C for 15 sec and the presence or absence of pattern abnormality was evaluated by observation.

In respective test multi-layer substrates using the polyimide films of IF Production Examples 10 - 15, no detachment of the pattern was observed. In respective test multi-layer substrates using the polyimide films of IF Production Examples 16 - 18, however, detachment of the pattern was observed.

In addition, for observation of the section, each test multi-layer substrate was cut in the direction allowing exposure of the section in the width direction of the ultrafine wire pattern, embedded in a resin, polished at the end surface and observed under a microscope in an enlarged view. It was evaluated whether the adhesive sheet between the test multi-layer substrates had a deformation.

In respective test multi-layer substrates using the polyimide films of IF Production Examples 10 - 15, no deformation of adhesive sheet was observed. In respective test multi-layer substrates using the polyimide films of IF Production Examples 16 - 18, however, deformation of adhesive sheet was observed.

(Examples 25 - 30, Comparative Examples 13 - 15)

<Production of adhesive sheet>

Using each polyimide film obtained in Production Examples 1 - 9, adhesive sheets were obtained according to the following.

N-Methyl-2-pyrrolidone was placed in a reaction vessel equipped with a stirrer and a nitrogen inlet tube, 1,3-bis(4-aminophenoxy)benzene and 2,3,3',4'-biphenyltetracarboxylic acid dianhydride at a molar ratio of 1000:1000 were added to a monomer concentration of 22 mass %, and further, triphenyl phosphate was added in a proportion of 0.1 mass % relative to the monomer weight. After the completion of addition, the reaction was continued for 1 hr while maintaining at 25˚C to give a polyamic acid (SA1) solution. The obtained polyamic acid showed ηsp/C 1.6.

Using a double coater, SA1 was applied to one surface of each polyimide film obtained in the Production Examples to a drying thickness of 7 μm and dried at 90˚C for 30 min. The film after drying was passed through a continuous heat treating furnace, the temperature was raised from 200˚C to 380˚C almost linearly over 20 min and cooled over 10 min, and each single-sided adhesive sheet which was each thermocompression bonding multi-layer polyimide film wherein 4 μm-thick thermoplastic polyimide was provided on one surface of each 15 μm-thick brown polyimide film was obtained (KTS Examples 25 - 30 and KTS Comparative Examples 13 - 15; each polyimide film obtained in the above-mentioned Production Examples 1 - 6 was used in KTS Examples 25 - 30, and each polyamide film obtained in the above-mentioned Production Examples 7 - 9 was used in KTS Comparative Examples 13 - 15, hereinafter the same).

Similarly, this SA1 was applied to both surfaces of each polyimide film obtained in the aforementioned Production Examples to a drying thickness of 7 $\mu$m with a double coater and dried at 90°C for 30 min. The film after drying was passed through a continuous heat treating furnace, the temperature was raised from 200°C to 380°C almost linearly over 20 min and cooled over 10 min, and each double-sided adhesive sheet which was each thermocompression bonding multi-layer polyimide film wherein 4 $\mu$m-thick thermoplastic polyimide was provided on both surfaces of each 15 $\mu$m-thick brown polyimide film was obtained (RYS Examples 25 - 30 and RYS Comparative Examples 13 - 15). The total thickness of the polyimide film and the adhesive layer in the obtained each double-sided adhesive sheet was 23$\mu$ m.

The obtained each adhesive sheet was evaluated by an average of the degree of warpage. Each sheet having an average degree of warpage exceeding 10% was rated ×, a sheet having a degree of warpage exceeding 7% and up to 10% was rated △, a sheet showing 3 - 7% was rated ○, and a sheet showing less than 3% was rated ⊙.

As a result, all of KTS Example 25, KTS Example 26 and KTS Example 28 were ⊙, KTS Example 27 and KTS Example 29 were ○, KTS Example 30 was △, and all of KTS Comparative Example 13, KTS Comparative Example 14 and KTS Comparative Example 15 were ×.

All of RYS Example 25, RYS Example 26, RYS Example 27, RYS Example 28 and Example 29 were ⊙, RYS Example 30 was ○, RYS Comparative Example 13 was △, and RYS Comparative Example 14 and RYS Comparative Example 15 were ×.

<Production of metal-laminated sheet>

Using a roll inside heating and outside heating combination type thermocompression bonding machine, the roll surface temperature was raised to 240°C by heating. The obtained thermocompression bonding multi-layer polyimide film was passed between rolls, a 18 $\mu$m-thick electrolytic copper foil (CF-T9, manufactured by FUKUDA METAL FOIL & POWDER CO., LTD.) was supplied from both sides thereof, and each polyimide film made of a copper foil/thermal adhesiveness multi-layer polyimide film/copper foil was used to give each double-sided metal-laminated sheet (RYM Examples 25 - 30 and RYM Comparative Examples 13 - 15).

The obtained each metal-laminated sheet was evaluated by an average of the degree of warpage. Each metal-laminated sheet having an average degree of warpage exceeding 10% was rated ×, a sheet having a degree of warpage exceeding 7% and up to 10% was rated △, a sheet showing 3 - 7% was rated ○, and a sheet showing less than 3% was rated ⊙.

As a result, all of RYM Example 25, RYM Example 26, RYS Example 27, RYM Example 28 and RYM Example 29 were ⊙, RYM Example 30 was ○, RYM Comparative Example 13 was △, and RYM Comparative Example 14 and RYM Comparative Example 15 were ×.

<Production of printed circuit board>

A negative resist having a film thickness of 6 $\mu$m was formed using a liquid resist on one surface of each double-sided metal-laminated sheet prepared above, and a copper layer was removed by etching to form a 4.8 cm×4.8 cm test circuit pattern containing an ultrafine wire with wire interval/wire width of 60 $\mu$m/40 $\mu$m and assuming mounting on LCD driver. In the same manner as above, a 4 mm square pattern was formed on the backside in a lattice shape wherein the distance between patterns was 0.5 mm, and a number of test circuit substrates (TPR Examples 25 - 30 and TPR Comparative Examples 13 - 15) were prepared in the same manner from each polyimide film. The pattern area density was 50% for both the front and the back.

Three sheets of each test circuit substrate prepared were produced, each adhesive sheet of Examples 25 - 30, Comparative Examples 13 - 15 was set between respective test circuit substrates (RYS Examples 25 - 30 and RYS Comparative Examples 13 - 15), and each single-sided adhesive sheet of Examples 25 - 30, Comparative Examples 13 - 15 was set on the outermost layer of each test circuit substrate (KTS Examples 25 - 30 and KTS Comparative Examples 13 - 15) such that they are constituted with the same polyimide film, they were laminated by thermocompression bonding to give respective test multi-layer substrates.

In respective test multi-layer substrates from the polyimide films of IF Production Examples 1 - 6, no detachment of the pattern was observed. In respective test multi-layer substrates from the polyimide films of IF Production Examples 7 - 9, however, detachment of the pattern was observed.

In addition, for observation of the section, each test multi-layer substrate was cut in the direction allowing exposure of the section in the width direction of the ultrafine wire pattern, embedded in a resin, polished at the end surface and observed under a microscope in an enlarged view. It was evaluated whether the adhesive sheet between the test multi-layer substrates had a deformation. In respective test multi-layer substrates using the polyimide films of IF Production Examples 1 - 6, no deformation of adhesive sheet was observed. In respective test multi-layer substrates using the polyimide films of IF Production Examples 7 - 9, however, deformation of adhesive sheet was observed.

(Examples 31 - 36, Comparative Examples 16 - 18)

<Production of adhesive sheet>

Using each polyimide film obtained in Production Examples 10 - 18, adhesive sheets were obtained according to the following.

N-Methyl-2-pyrrolidone was placed in a reaction vessel equipped with a stirrer and a nitrogen inlet tube, 1,3-bis(4-aminophenoxy)benzene and 2,3,3',4'-biphenyltetracarboxylic acid dianhydride at a molar ratio of 1000:1000 were added to a monomer concentration of 22 mass %, and further, triphenyl phosphate was added in a proportion of 0.1 mass % relative to the monomer mass. After the completion of addition, the reaction was continued for 1 hr while maintaining at 25°C to give a polyamic acid (SA1) solution. The obtained polyamic acid showed ηsp/C 1.6.

Using a double coater, SA1 was applied to one surface of each polyimide film obtained in the Production Examples to a drying thickness of 7 μm and dried at 90°C for 30 min. The film after drying was passed through a continuous heat treating furnace, the temperature was raised from 200°C to 380°C almost linearly over 20 min and cooled over 10 min, and each single-sided adhesive sheet which was each thermocompression bonding multi-layer polyimide film wherein 4 μm-thick thermoplastic polyimide was provided on one surface of each 15 μm-thick brown polyimide film was obtained (KTS Examples 31 - 36 and KTS Comparative Examples 16 - 18; each polyimide film obtained in the above-mentioned Production Examples 10 - 15 was used in KTS Examples 31 - 36, and each polyamide film obtained in the above-mentioned Production Examples 16 - 18 was used in KTS Comparative Examples 16 - 18, hereinafter the same).

Similarly, this SA1 was applied to both surfaces of each polyimide film obtained in the Production Examples to a drying thickness of 7 μm with a double coater and dried at 90°C for 30 min. The film after drying was passed through a continuous heat treating furnace, the temperature was raised from 200°C to 380°C almost linearly over 20 min and cooled over 10 min, and each double-sided adhesive sheet which was each thermocompression bonding multi-layer polyimide film wherein 4 μm-thick thermoplastic polyimide was provided on both surfaces of each 15 μm-thick brown polyimide film was obtained (RYS Examples 31 - 36 and RYS Comparative Examples 16 - 18). The total thickness of the polyimide film and the adhesive layer in the obtained each double-sided adhesive sheet was 23 μm.

The obtained each adhesive sheet was evaluated by an average of the degree of warpage. Each sheet having an average degree of warpage exceeding 10% was rated ×, a sheet having a degree of warpage exceeding 7% and up to 10% was rated Δ, a sheet showing 3 - 7% was rated ○, and a sheet showing less than 3% was rated ⊙.

As a result, all of KTS Example 31, KTS Example 32 and KTS Example 34 were ⊙, KTS Example 33 and KTS Example 35 were ○, KTS Example 36 was Δ, and all of KTS Comparative Example 16, KTS Comparative Example 17 and KTS Comparative Example 18 were ×.

All of RYS Example 31, RYS Example 32, RYS Example 33, RYS Example 34 and RYS Example 35 were ⊙, RYS Example 36 was ○, RYS Comparative Example 16 was Δ, and RYS Comparative Example 17 and RYS Comparative Example 18 were ×.

<Production of metal-laminated sheet>

Using a roll inside heating and outside heating combination type thermocompression bonding machine, the roll surface temperature was raised to 240°C by heating. The obtained thermocompression bonding multi-layer polyimide film was passed between rolls, a 18 μm-thick electrolytic copper foil (CF-T9, manufactured by FUKUDA METAL FOIL & POWDER CO., LTD.) was supplied from both sides thereof, and each polyimide film made of a copper foil/thermal adhesiveness multi-layer polyimide film/copper foil was used to give each double-sided metal-laminated sheet (RYM Examples 31 - 36 and RYM Comparative Examples 16 - 18).

The obtained each metal-laminated sheet was evaluated by an average of the degree of warpage. Each metal-laminated sheet having an average degree of warpage exceeding 10% was rated ×, a sheet having a degree of warpage exceeding 7% and up to 10% was rated Δ, a sheet showing 3 - 7% was rated ○, and a sheet showing less than 3% was rated ⊙.

As a result, all of RYM Example 31, RYM Example 32, RYS Example 33, RYM Example 34 and RYM Example 35 were ⊙, RYM Example 36 was ○, RYM Comparative Example 16 was Δ, and RYM Comparative Example 17 and RYM Comparative Example 18 were ×.

<Production of printed circuit board>

A negative resist having a film thickness of 6 μm was formed using a liquid resist on one surface of each double-sided metal-laminated sheet prepared above, and a copper layer was removed by etching to form a 4.8 cmx4.8 cm test circuit pattern containing an ultrafine wire with wire interval/wire width of 60 μm/40 μm and assuming mounting

on LCD driver. In the same manner as above, a 4 mm square pattern was formed on the backside in a lattice shape wherein the distance between patterns was 0.5 mm, and a number of test circuit substrates (TPR Examples 31 - 36 and TPR Comparative Examples 16 - 18) were prepared in the same manner using each polyimide film. The pattern area density was 50% for both the front and the back.

Three sheets of each test circuit substrate prepared were produced, each adhesive sheet of Examples 31 - 36, Comparative Examples 16 - 18 was set between respective test circuit substrates (RYS Examples 31 - 36 and RYS Comparative Examples 16 - 18), and each single-sided adhesive sheet of Examples 31 - 36, Comparative Examples 16 - 18 was set on the outermost layer of each test circuit substrate (KTS Examples 31 - 36 and KTS Comparative Examples 16 - 18) such that they are constituted with the same polyimide film, they were laminated by thermocompression bonding to give respective test multi-layer substrates.

In respective test multi-layer substrates from the polyimide films of IF Production Examples 10 - 15, no detachment of the pattern was observed. In respective test multi-layer substrates from the polyimide films of IF Production Examples 16 - 18, however, detachment of the pattern was observed.

In addition, for observation of the section, each test multi-layer substrate was cut in the direction allowing exposure of the section in the width direction of the ultrafine wire pattern, embedded in a resin, polished at the end surface and observed under a microscope in an enlarged view. It was evaluated whether the adhesive sheet between the test multi-layer substrates had a deformation.

In respective test multi-layer substrates using the polyimide films of IF Production Examples 10 - 15, no deformation of adhesive sheet was observed. In respective test multi-layer substrates using the polyimide films of IF Production Examples 16 - 18, however, deformation of adhesive sheet was observed.

**Industrial Applicability**

According to the present invention, an adhesive sheet, a metal-laminated sheet and a printed circuit board using a polyimide film as a substrate film can be provided. For example, in a printed circuit board, a metal foil layer is formed on one surface or both surfaces of a polyimide film and, for example, a wiring pattern having a wire width of 5 - 30 $\mu$m, wire interval of 5 - 30 $\mu$m and a thickness of about 3 - 40 $\mu$m is formed by removing the unnecessary part from the metal foil layer.

While a heat treatment and the like during this metal foil layer lamination influence the substrate film, using, during various treatments, an adhesive sheet and the like constituted with a polyimide film showing property difference between the front and the back surfaces thereof, particularly a degree of curl after a heat treatment of the film at 300°C, at a certain level or below, the polyimide film hardly shows warpage or distortion particularly during a high temperature treatment. As a result, the quality and yield of the obtained printed circuit board and the like are improved. The film can maintain planarity even after a subsequent high temperature treatment applied to such printed circuit board and the like (e.g., anneal treatment, solder treatment and the like). Thus, the product yield thereof can be improved.

As mentioned above, the polyimide film as a heat resistance film is often exposed to heat, where a low degree of curl of the film due to heat after a heat treatment at 300°C is an extremely important quality when the film is applied to a substrate and the like of an industrial product.

An adhesive sheet, a metal-laminated sheet and a printed circuit board using a particular polyimide film of the present invention are industrially extremely significant because use thereof as electronic parts and the like to be exposed to a high temperature prevents easy development of warpage and distortion of the substrate during production, and can improve quality and yield of electronic parts.

This application is based on patent application Nos. 2005-122566, 2005-122567, 2005-122568 and 2005-122569 filed in Japan, the contents of which are incorporated in full herein by this reference.

**Claims**

**1.** An adhesive sheet comprising, as a substrate film, a polyimide film having a degree of curl after a heat treatment at 300°C of not more than 10%, and an adhesive layer formed on at least one surface of the substrate film.

**2.** The adhesive sheet of claim 1, wherein the degree of curl after the heat treatment at 300°C is not more than 8%.

**3.** The adhesive sheet of claim 1 or 2, wherein the polyimide film is made of a polyimide obtained by reacting aromatic tetracarboxylic acid with aromatic diamine.

**4.** The adhesive sheet of claim 3, wherein the polyimide comprises at least a pyromellitic acid residue as an aromatic tetracarboxylic acid residue, and at least a diaminodiphenyl ether residue as an aromatic diamine residue.

**5.** The adhesive sheet of claim 4, further comprising a biphenyltetracarboxylic acid residue as an aromatic tetracarboxylic acid residue and a p-phenylenediamine residue as an aromatic diamine residue.

**6.** The adhesive sheet of claim 3, wherein the polyimide comprises at least a biphenyltetracarboxylic acid residue as an aromatic tetracarboxylic acid residue, and at least a phenylenediamine residue as an aromatic diamine residue.

**7.** The adhesive sheet of any of claims 1 to 6, wherein the adhesive constituting the adhesive layer is a thermosetting adhesive.

**8.** The adhesive sheet of any of claims 1 to 6, wherein the adhesive constituting the adhesive layer is a thermoplastic adhesive.

**9.** A metal-laminated sheet wherein a metal foil is laminated on the adhesive layer of the adhesive sheet of any of claims 1 to 8.

**10.** A printed circuit board comprising the metal-laminated sheet of claim 9, wherein a part of the metal foil is removed.

**11.** A printed circuit board comprising a laminate of plural printed circuit boards of claim 10.

**12.** A printed circuit board comprising the printed circuit board of claim 10 or 11 and a semiconductor chip mounted thereon.

**13.** A semiconductor package comprising the printed circuit board of claim 10 or 11 and a semiconductor chip mounted thereon.

# FIG. 1

(a)

50mm

50mm

(b)

(c)

h1    h4

# FIG. 2

# FIG. 3

**INTERNATIONAL SEARCH REPORT**

| International application No. |
| --- |
| PCT/JP2005/012624 |

**A. CLASSIFICATION OF SUBJECT MATTER**
*B32B27/34*(2006.01)

According to International Patent Classification (IPC) or to both national classification and IPC

**B. FIELDS SEARCHED**

Minimum documentation searched (classification system followed by classification symbols)
*B32B1/00-35/00*(2006.01)

Documentation searched other than minimum documentation to the extent that such documents are included in the fields searched
Jitsuyo Shinan Koho          1922-1996   Jitsuyo Shinan Toroku Koho   1996-2005
Kokai Jitsuyo Shinan Koho    1971-2005   Toroku Jitsuyo Shinan Koho   1994-2005

Electronic data base consulted during the international search (name of data base and, where practicable, search terms used)
WPI

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | JP 2004-211071 A  (E.I. Du Pont De Nemours & Co.),<br>29 July, 2004 (29.07.04),<br>Claims; Par. Nos. [0015], [0078], [0087], [0088]; examples<br>& US 2004/126600 A1 | 1-4,7-13<br>5,6 |
| X | JP 11-177195 A  (Ube Industries, Ltd.),<br>02 July, 1999 (02.07.99),<br>Claims; Par. Nos. [0003], [0004], [0014] to [0017], [0021], [0023], [0024]<br>(Family: none) | 1-13 |
| Y | JP 2000-85007 A  (Du Pont-Toray Co., Ltd.),<br>28 March, 2000 (28.03.00),<br>Par. No. [0025]<br>(Family: none) | 5,6 |

[ ] Further documents are listed in the continuation of Box C.       [ ] See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>   25 October, 2005 (25.10.05) | Date of mailing of the international search report<br>   15 November, 2005 (15.11.05) |
| --- | --- |
| Name and mailing address of the ISA/<br>   Japanese Patent Office | Authorized officer |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003089784 A
- JP 2000143981 A
- JP 2000144092 A
- JP 2003306649 A
- JP 2003011308 A
- JP 2000085007 A
- WO 2005122566 A
- WO 2005122567 A
- WO 2005122568 A
- WO 2005122569 A